# EUROPEAN PATENT APPLICATION

(11) **EP 4 672 515 A1**
(43) Date of publication of application: **31.12.2025**
(21) Application number: 25185677.9
(22) Date of filing: 26.06.2025
(51) Int. Cl.: H01R 13/66, H05K 1/14, H01R 12/78, H01R 13/645, H01R 24/86, H01R 12/70

(54) **ELECTRICAL CONNECTOR**

(30) Priority: 29.06.2024 US 202418759856
(71) Applicant: ATL Technology, LLC, Springville, UT 84663 (US)
(72) Inventor: Yang, Tyler, Provo, Utah (US); Goff, Darrell E., Highland, Utah (US)
(74) Representative: Forresters IP LLP

(57) **Abstract**

An electrical connector includes a first connector element and a second connector element. The first connector element includes a first annular flexible circuit board and first electrical contacts coupled to the first annular flexible circuit board in at least one first annular pattern. The second connector element includes a leading end and second electrical contacts. Each one of the second electrical contacts is a flexible electrical contact that includes a fixed portion directly attached to the second annular flexible circuit board and a movable portion that is movable relative to the fixed portion. The movable portion is radially outwardly angled away from the leading end of the second connector element. Each one of the first electrical contacts of the first connector element is in physical contact with a corresponding one of the second electrical contacts of the second connector element.

## Description

### CROSS-REFERENCES TO RELATED APPLICATIONS

This application claims priority to U.S. Patent Application No. 18/759,856, filed Jun 29, 2024, which is incorporated herein by reference in its entirety.

### FIELD

This application relates generally to electrical components, and more specifically to an electrical connector having a plug and a receptacle.

### BACKGROUND

Conventional high-density electrical connectors include planar rows of stacked electrical contact boards. Because any one of the boards may unpredictably act as a primary datum, as a plug of the connector is inserted into a receptacle of the connector, misalignment of or unreliable connections between the other of the boards may occur. Accordingly, predictably aligning multiple groupings of electrical contacts in a high-density electrical connector can be difficult. Additionally, manufacturing a high-density electrical connector in a cost-effective and efficient manner can also be difficult.

### SUMMARY

The subject matter of the present application has been developed in response to the present state of the art, and in particular, in response to the problems and needs of conventional devices or products for providing a high-density electrical connection between a tool and a tool control system that have not yet been fully solved. The subject matter of the present application has been developed to provide an electrical connector that facilitates a high-density electrical connection that overcomes many of the shortcomings of the prior art.

Disclosed herein is an electrical connector that includes a first connector element and a second connector element. The first connector element includes a first annular flexible circuit board and first electrical contacts coupled to the first annular flexible circuit board, electrically isolated from each other, and arranged in at least one first annular pattern. The second connector element includes a leading end, a second annular flexible circuit board, and second electrical contacts coupled to the second annular flexible circuit board, electrically isolated from each other, and arranged in at least one second annular pattern. Each one of the second electrical contacts is a flexible electrical contact that includes a fixed portion directly attached to the second annular flexible circuit board and a movable portion that is movable relative to the fixed portion. The movable portion is radially outwardly angled away from the leading end of the second connector element. The leading end of the second connector element is selectively connectable with the first connector element. When the second connector element is selectively connected with the first connector element, each one of the first electrical contacts of the first connector element is in physical contact with a corresponding one of the second electrical contacts of the second connector element. The preceding subject matter of this paragraph characterizes example 1 of the present disclosure.

The first electrical contacts of the first connector element are electrical contact pads. The preceding subject matter of this paragraph characterizes example 2 of the present disclosure, wherein example 2 also includes the subject matter according to example 1, above.

The first annular flexible circuit board of the first connector element includes a first outer surface and a first inner surface separated from the first outer surface by a thickness of the first annular flexible circuit board. The at least one first annular pattern is attached to the first inner surface of the first annular flexible circuit board. The second annular flexible circuit board of the second connector element includes a second outer surface and a second inner surface separated from the first outer surface by a thickness of the second annular flexible circuit board. The at least one second annular pattern is attached to the second outer surface of the second annular flexible circuit board. The preceding subject matter of this paragraph characterizes example 3 of the present disclosure, wherein example 3 also includes the subject matter according to any of examples 1-2, above.

The first connector element includes a plurality of first annular patterns attached to the first inner surface of the first annular flexible circuit board and spaced apart from each other. The second connector element includes a plurality of second annular patterns attached to the second outer surface of the second annular flexible circuit board and spaced apart from each other. The preceding subject matter of this paragraph characterizes example 4 of the present disclosure, wherein example 4 also includes the subject matter according to example 3, above.

The movable portion of each one of the flexible electrical contacts includes an elongated arm that extends, in a direction away from the leading end of the second connector element, from a fixed end, fixed to the fixed portion, to a cantilevered end. The preceding subject matter of this paragraph characterizes example 5 of the present disclosure, wherein example 5 also includes the subject matter according to any of examples 1-4, above.

The second annular flexible circuit board includes mounting pads electrically isolated from each other and arranged in at least one mounting-pad annular pattern. The fixed portion of each one of the flexible electrical contacts is electrically and mechanically coupled directly with a corresponding one of the mounting pads. The preceding subject matter of this paragraph characterizes example 6 of the present disclosure, wherein example 6 also includes the subject matter according to any of examples 1-5, above.

The fixed portion of each one of the flexible electrical contacts includes a jog. Each one of the mounting pads includes a contact aperture. The jog of the fixed portion of each one of the flexible electrical contacts extends through the contact aperture of the corresponding one of the mounting pads. The preceding subject matter of this paragraph characterizes example 7 of the present disclosure, wherein example 7 also includes the subject matter according to example 6, above.

The jog of the fixed portion of each one of the flexible electrical contacts is soldered to the corresponding one of the mounting pads. The preceding subject matter of this paragraph characterizes example 8 of the present disclosure, wherein example 8 also includes the subject matter according to example 7, above.

The second connector element further includes a central engagement element. The second annular flexible circuit board is attached to the central engagement element. The central engagement element includes at least one annular channel. The jog of the fixed portion of each one of the flexible electrical contacts arranged in the at least one second annular pattern extends into the at least one annular channel. The preceding subject matter of this paragraph characterizes example 9 of the present disclosure, wherein example 9 also includes the subject matter according to any of examples 7-8, above.

The fixed portion of each one of the flexible electrical contacts is electrically and mechanically coupled directly with the corresponding one of the mounting pads via surface mount technology. The preceding subject matter of this paragraph characterizes example 10 of the present disclosure, wherein example 10 also includes the subject matter according to any of examples 6-9, above.

At least one of: (i) the first connector element includes a first housing having a plurality of posts, the first annular flexible circuit board includes opposing first side portions overlapping each other and each including a plurality of openings, each one of the openings of a first one of the opposing first side portions is aligned with a corresponding one of the openings of a second one of the opposing first side portions, and each one of the plurality of posts passes through a corresponding one of multiple pairs of aligned openings of the opposing first side portions; or (ii) the second connector element includes a second housing that includes a plurality of posts, the second annular flexible circuit board includes opposing second side portions overlapping each other and each including a plurality of openings, each one of the openings of a first one of the opposing second side portions is aligned with a corresponding one of the openings of a second one of the opposing second side portions, and each one of the plurality of posts passes through a corresponding one of multiple pairs of aligned openings of the opposing second side portions. The preceding subject matter of this paragraph characterizes example 11 of the present disclosure, wherein example 11 also includes the subject matter according to any of examples 1-10, above.

When the first connector element includes a first housing that includes a plurality of posts, each one of the plurality of posts has a retention portion larger than the aligned openings of the corresponding one of the multiple pairs of aligned openings of the opposing first side portions so that each one of the multiple pairs of aligned openings of the opposing first side portions is retained on a corresponding one of the plurality of posts. When the second connector element includes a second housing that includes a plurality of posts, each one of the plurality of posts has a retention portion larger than the aligned openings of the corresponding one of the multiple pairs of aligned openings of the opposing second side portions so that each one of the multiple pairs of aligned openings of the opposing second side portions is retained on a corresponding one of the plurality of posts. The preceding subject matter of this paragraph characterizes example 12 of the present disclosure, wherein example 12 also includes the subject matter according to example 11, above.

When the first connector element includes a first housing that includes a plurality of posts, the plurality of posts of the first housing are retained within the multiple pairs of aligned openings via an adhesive. When the second connector element includes a housing that includes a plurality of posts, the plurality of posts of the second housing are retained within the multiple pairs of aligned openings via an adhesive. The preceding subject matter of this paragraph characterizes example 13 of the present disclosure, wherein example 13 also includes the subject matter according to any of examples 11-12, above.

At least one of the first annular flexible circuit board includes opposing first side portions joined together by a plurality of first solder bridges, or the second annular flexible circuit board includes opposing second side portions joined together by a plurality of second solder bridges. The preceding subject matter of this paragraph characterizes example 14 of the present disclosure, wherein example 14 also includes the subject matter according to any of examples 1-13, above.

At least one of the first annular flexible circuit board includes opposing first side portions overlapping each other and joined together by solder, or the second annular flexible circuit board includes opposing second side portions overlapping each other and joined together by solder. The preceding subject matter of this paragraph characterizes example 15 of the present disclosure, wherein example 15 also includes the subject matter according to any of examples 1-14, above.

The second connector element includes an inner annular chamfer configured to slidably engage the first annular flexible circuit board as the second connector element is selectively connected with the first connector element and when the first annular flexible circuit is radially inwardly lopsided. The preceding subject matter of this paragraph characterizes example 16 of the present disclosure, wherein example 16 also includes the subject matter according to any of examples 1-15, above.

The second connector element includes an outer annular chamfer configured to slidably engage the first annular flexible circuit board as the second connector element is selectively connected with the first connector element and when the first annular flexible circuit is radially outwardly lopsided. The preceding subject matter of this paragraph characterizes example 17 of the present disclosure, wherein example 17 also includes the subject matter according to any of examples 1-16, above.

The second connector element includes an inner annular chamfer configured to slidably engage the first annular flexible circuit board as the second connector element is selectively connected with the first connector element and when the first annular flexible circuit is radially inwardly lopsided. The inner annular chamfer is axially offset, along a central axis of the electrical connector, relative to the outer annular chamfer. The preceding subject matter of this paragraph characterizes example 18 of the present disclosure, wherein example 18 also includes the subject matter according to example 17, above.

The first electrical contacts are arranged in at least two first annular patterns. The first electrical contacts of a first one of the at least two first annular patterns are staggered relative to the first electrical contacts of a second one of the at least two first annular patterns. The second electrical contacts are arranged in at least two second annular patterns. The second electrical contacts of a first one of the at least two second annular patterns are staggered relative to the second electrical contacts of a second one of the at least two second annular patterns. The preceding subject matter of this paragraph characterizes example 19 of the present disclosure, wherein example 19 also includes the subject matter according to any of examples 1-18, above.

The first connector element further includes a first central interface concentric with the first annular flexible circuit board, located radially inwardly relative to the first annular flexible circuit board, and including at least one of a first electrical connector, a first fluidic connector, a first fiberoptic connector, or a first pneumatic connector. The second connector element further includes a second central interface concentric with the second annular flexible circuit board, located radially inwardly relative to the second annular flexible circuit board, and including at least one of a second electrical connector, a second fluidic connector, a second fiberoptic connector, or as second pneumatic connector. When the second connector element is selectively connected with the first connector element the at least one of the first electrical connector, the first fluidic connector, the first fiberoptic connector, or the first pneumatic connector is electrically, fluidically, fiberoptically, or pneumatically connected with a corresponding one of the at least one of the second electrical connector, the second fluidic connector, the second fiberoptic connector, or the second pneumatic connector. The preceding subject matter of this paragraph characterizes example 20 of the present disclosure, wherein example 20 also includes the subject matter according to any of examples 1-19, above.

There is also provided an electrical connector, comprising: a first connector element comprising: a first annular flexible circuit board; and first electrical contacts coupled to the first annular flexible circuit board, electrically isolated from each other, and arranged in at least one first annular pattern; and a second connector element comprising: a leading end; a second annular flexible circuit board; and second electrical contacts coupled to the second annular flexible circuit board, electrically isolated from each other, and arranged in at least one second annular pattern, wherein each one of the second electrical contacts is a flexible electrical contact that comprises a fixed portion directly attached to the second annular flexible circuit board and a movable portion that is movable relative to the fixed portion, and wherein the movable portion is radially outwardly angled away from the leading end of the second connector element; wherein: the leading end of the second connector element is selectively connectable with the first connector element; and when the second connector element is selectively connected with the first connector element, each one of the first electrical contacts of the first connector element is in physical contact with a corresponding one of the second electrical contacts of the second connector element.

The first electrical contacts of the first connector element may be electrical contact pads.

The first annular flexible circuit board of the first connector element may comprise a first outer surface and a first inner surface separated from the first outer surface by a thickness of the first annular flexible circuit board. The at least one first annular pattern may be attached to the first inner surface of the first annular flexible circuit board. The second annular flexible circuit board of the second connector element may comprise a second outer surface and a second inner surface separated from the first outer surface by a thickness of the second annular flexible circuit board. The at least one second annular pattern may be attached to the second outer surface of the second annular flexible circuit board.

The first connector element may comprise a plurality of first annular patterns attached to the first inner surface of the first annular flexible circuit board and spaced apart from each other. The second connector element may comprise a plurality of second annular patterns attached to the second outer surface of the second annular flexible circuit board and spaced apart from each other.

The movable portion of each one of the flexible electrical contacts may comprise an elongated arm that extends, in a direction away from the leading end of the second connector element, from a fixed end, fixed to the fixed portion, to a cantilevered end.

The second annular flexible circuit board may comprise mounting pads electrically isolated from each other and arranged in at least one mounting-pad annular pattern. The fixed portion of each one of the flexible electrical contacts may be electrically and mechanically coupled directly with a corresponding one of the mounting pads.

The fixed portion of each one of the flexible electrical contacts may comprise a jog. Each one of the mounting pads may comprise a contact aperture. The jog of the fixed portion of each one of the flexible electrical contacts may extend through the contact aperture of the corresponding one of the mounting pads.

The jog of the fixed portion of each one of the flexible electrical contacts may be soldered to the corresponding one of the mounting pads.

The second connector element may further comprise a central engagement element. The second annular flexible circuit board may be attached to the central engagement element. The central engagement element may comprise at least one annular channel. The jog of the fixed portion of each one of the flexible electrical contacts arranged in the at least one second annular pattern may extend into the at least one annular channel.

The fixed portion of each one of the flexible electrical contacts may be electrically and mechanically coupled directly with the corresponding one of the mounting pads via surface mount technology.

The first connector element may comprise a first housing that comprises a plurality of posts. The first annular flexible circuit board may comprise opposing first side portions overlapping each other and each comprising a plurality of openings. Each one of the openings of a first one of the opposing first side portions may be aligned with a corresponding one of the openings of a second one of the opposing first side portions. Each one of the plurality of posts may pass through a corresponding one of multiple pairs of aligned openings of the opposing first side portions. The second connector element may comprise a second housing that comprises a plurality of posts. The second annular flexible circuit board may comprise opposing second side portions overlapping each other and each comprising a plurality of openings. Each one of the openings of a first one of the opposing second side portions may be aligned with a corresponding one of the openings of a second one of the opposing second side portions. Each one of the plurality of posts may pass through a corresponding one of multiple pairs of aligned openings of the opposing second side portions.

When the first connector element comprises a first housing that comprises a plurality of posts, each one of the plurality of posts may have a retention portion larger than the aligned openings of the corresponding one of the multiple pairs of aligned openings of the opposing first side portions so that each one of the multiple pairs of aligned openings of the opposing first side portions is retained on a corresponding one of the plurality of posts. When the second connector element comprises a second housing that comprises a plurality of posts, each one of the plurality of posts may have a retention portion larger than the aligned openings of the corresponding one of the multiple pairs of aligned openings of the opposing second side portions so that each one of the multiple pairs of aligned openings of the opposing second side portions is retained on a corresponding one of the plurality of posts.

When the first connector element comprises a first housing that comprises a plurality of posts, the plurality of posts of the first housing may be retained within the multiple pairs of aligned openings via an adhesive. When the second connector element comprises a second housing that comprises a plurality of posts, the plurality of posts of the second housing may be retained within the multiple pairs of aligned openings via an adhesive.

The first annular flexible circuit board may comprise opposing first side portions joined together by a plurality of first solder bridges. The second annular flexible circuit board may comprise opposing second side portions joined together by a plurality of second solder bridges.

The first annular flexible circuit board may comprise opposing first side portions overlapping each other and joined together by solder. The second annular flexible circuit board may comprise opposing second side portions overlapping each other and joined together by solder.

The second connector element may comprise an inner annular chamfer configured to slidably engage the first annular flexible circuit board as the second connector element is selectively connected with the first connector element and when the first annular flexible circuit is radially inwardly lopsided.

The second connector element may comprise an outer annular chamfer configured to slidably engage the first annular flexible circuit board as the second connector element is selectively connected with the first connector element and when the first annular flexible circuit is radially outwardly lopsided.

The second connector element may comprise an inner annular chamfer configured to slidably engage the first annular flexible circuit board as the second connector element is selectively connected with the first connector element and when the first annular flexible circuit is radially inwardly lopsided. The inner annular chamfer may be axially offset, along a central axis of the electrical connector, relative to the outer annular chamfer.

The first electrical contacts may be arranged in at least two first annular patterns. The first electrical contacts of a first one of the at least two first annular patterns may be staggered relative to the first electrical contacts of a second one of the at least two first annular patterns. The second electrical contacts may be arranged in at least two second annular patterns. The second electrical contacts of a first one of the at least two second annular patterns may be staggered relative to the second electrical contacts of a second one of the at least two second annular patterns.

The first connector element may further comprise a first central interface concentric with the first annular flexible circuit board, located radially inwardly relative to the first annular flexible circuit board. The first connector element may comprise at least one of a first electrical connector, a first fluidic connector, a first fiberoptic connector, or a first pneumatic connector. The second connector element may further comprise a second central interface concentric with the second annular flexible circuit board, located radially inwardly relative to the second annular flexible circuit board. The second connector element may comprise at least one of a second electrical connector, a second fluidic connector, a second fiberoptic connector, or a second pneumatic connector. When the second connector element is selectively connected with the first connector element the at least one of the first electrical connector, the first fluidic connector, the first fiberoptic connector, or the first pneumatic connector may be electrically, fluidically, fiberoptically, or pneumatically connected with a corresponding one of the at least one of the second electrical connector, the second fluidic connector, the second fiberoptic connector, or the second pneumatic connector.

The described features, structures, advantages, and/or characteristics of the subject matter of the present disclosure may be combined in any suitable manner in one or more embodiments and/or implementations. In the following description, numerous specific details are provided to impart a thorough understanding of embodiments of the subject matter of the present disclosure. One skilled in the relevant art will recognize that the subject matter of the present disclosure may be practiced without one or more of the specific features, details, components, materials, and/or methods of a particular embodiment or implementation. In other instances, additional features and advantages may be recognized in certain embodiments and/or implementations that may not be present in all embodiments or implementations. Further, in some instances, well-known structures, materials, or operations are not shown or described in detail to avoid obscuring aspects of the subject matter of the present disclosure. The features and advantages of the subject matter of the present disclosure will become more fully apparent from the following description and appended claims, or may be learned by the practice of the subject matter as set forth hereinafter.

### BRIEF DESCRIPTION OF DRAWINGS

In order that the advantages of the subject matter may be more readily understood, a more particular description of the subject matter briefly described above will be rendered by reference to specific examples that are illustrated in the appended drawings. Understanding that these drawings, which are not necessarily drawn to scale, depict only certain examples of the subject matter and are not therefore to be considered to be limiting of its scope, the subject matter will be described and explained with additional specificity and detail through the use of the drawings, in which:
Figure 1 is a perspective view of an electrical connector, according to one or more examples of the present disclosure;
Figure 2 is a side elevation view of the electrical connector of Figure 1, according to one or more examples of the present disclosure;
Figure 3 is a perspective view of the electrical connector of Figure 1, showing a plug and a receptacle of the electrical connector separated and shown from a plug side of the electrical connector, according to one or more examples of the present disclosure;
Figure 4 is a perspective view of the electrical connector of Figure 1, showing the plug and the receptacle separated and shown from receptacle side of the electrical connector, according to one or more examples of the present disclosure;
Figure 5 is a perspective view of the electrical connector of Figure 1, showing the plug and the receptacle separated and shown from a plug side of the electrical connector and shown with housings removed, according to one or more examples of the present disclosure;
Figure 6 is a perspective view of the electrical connector of Figure 1, showing the plug and the receptacle separated, shown from receptacle side of the electrical connector and shown with housings removed, according to one or more examples of the present disclosure;
Figure 7 is a side elevation view of a receptacle of the electrical connector of Figure 1, shown with a housing of the receptacle removed, according to one or more examples of the present disclosure;
Figure 8 is a perspective view of the receptacle of the electrical connector of Figure 1, shown with the housing of the receptacle removed, according to one or more examples of the present disclosure;
Figure 9 is a side elevation view of a plug of the electrical connector of Figure 1, shown with a housing of the plug removed, according to one or more examples of the present disclosure;
Figure 10 is a perspective view of the plug of the electrical connector of Figure 1, shown with the housing of the plug removed, according to one or more examples of the present disclosure;
Figure 11 is a front elevation view of a receptacle of the electrical connector of Figure 1, shown with a housing of the receptacle removed, according to one or more examples of the present disclosure;
Figure 12 is a front elevation view of a plug of the electrical connector of Figure 1, shown with a housing of the plug removed, according to one or more examples of the present disclosure;
Figure 13 is a side elevation view of a plug of the electrical connector of Figure 1, shown with a housing and a contraflexure adjustment ring of the plug removed, according to one or more examples of the present disclosure;
Figure 14 is a perspective view of the electrical connector of Figure 1, shown with housings of a plug and a receptacle of the electrical connector removed, according to one or more examples of the present disclosure;
Figure 15 is a perspective view of a section of a contact-pad engagement portion of the electrical connector of Figure 1, according to one or more examples of the present disclosure;
Figure 16 is a side elevation view of a section of a contact-pad engagement portion of the electrical connector of Figure 1, according to one or more examples of the present disclosure;
Figure 17 is a perspective view of an annular flexible circuit board of a receptacle of the electrical connector of Figure 1, according to one or more examples of the present disclosure;
Figure 18 is another perspective view of the annular flexible circuit board of the receptacle of the electrical connector of Figure 1, according to one or more examples of the present disclosure;
Figure 19 is a side elevation view of an electrical connector, according to one or more examples of the present disclosure;
Figure 20 is a side elevation exploded view of the electrical connector of Figure 19, according to one or more examples of the present disclosure;
Figure 21 is a perspective view of the electrical connector of Figure 19, showing a plug and a receptacle of the electrical connector separated and shown from a plug side of the electrical connector, according to one or more examples of the present disclosure;
Figure 22 is a perspective view of the electrical connector of Figure 19, showing the plug and the receptacle separated and shown from a receptacle side of the electrical connector, according to one or more examples of the present disclosure;
Figure 23 is a side elevation view of the electrical connector of Figure 19, showing the plug and the receptacle separated and shown with housings of the plug and receptacle removed, according to one or more examples of the present disclosure;
Figure 24 is a side elevation view of the electrical connector of Figure 19, showing the plug and the receptacle coming into engagement and shown with housings of the plug and receptacle removed, according to one or more examples of the present disclosure;
Figure 25 is a side elevation view of the electrical connector of Figure 19, showing the plug and the receptacle engaged and shown with housings of the plug and receptacle removed, according to one or more examples of the present disclosure;
Figure 26 is a side elevation cross-sectional view of the electrical connector of Figure 19, taken along a plane within which a central axis of the electrical connector lies and showing the plug and the receptacle engaged, according to one or more examples of the present disclosure;
Figure 27 is a first perspective view of a flexible electrical contact of the electrical connector of Figure 19, according to one or more examples of the present disclosure;
Figure 28 is a second perspective view of the flexible electrical contact of Figure 27, according to one or more examples of the present disclosure;
Figure 29 is a front view of the flexible electrical contact of Figure 27, according to one or more examples of the present disclosure;
Figure 30 is a bottom plan view of the flexible electrical contact of Figure 27, according to one or more examples of the present disclosure;
Figure 31 is a side elevation view of the flexible electrical contact of Figure 27, according to one or more examples of the present disclosure;
Figure 32 is a side elevation cross-sectional view of a portion of the electrical connector of Figure 19, taken along a plane similar to that of Figure 26 and showing the plug and the receptacle coming into engagement, according to one or more examples of the present disclosure;
Figure 33 is a side elevation cross-sectional view of a portion of the electrical connector of Figure 19, taken along the plane similar to that of Figure 26 and showing the plug and the receptacle partially engaged, according to one or more examples of the present disclosure;
Figure 34 is a side elevation cross-sectional view of a portion of the electrical connector of Figure 19, taken along the plane similar to that of Figure 26 and showing the plug and the receptacle fully engaged, according to one or more examples of the present disclosure;
Figure 35 is a front elevation cross-sectional view of a portion of the electrical connector of Figure 19, taken along a plane perpendicular to a central axis of the electrical connector and shown when the plug and the receptacle are fully engaged, according to one or more examples of the present disclosure;
Figure 36 is a perspective view of an electrical connector, according to one or more examples of the present disclosure;
Figure 37 is another perspective view of the electrical connector of Figure 36, according to one or more examples of the present disclosure;
Figure 38 is a top plan view of an annular flexible circuit board of an electrical connector, according to one or more examples of the present disclosure;
Figure 39 is a perspective view of an electrical connector, according to one or more examples of the present disclosure;
Figure 40 is a perspective view of a plug of an electrical connector, shown with a housing of the plug removed, according to one or more examples of the present disclosure;
Figure 41 is a perspective view of flexible electrical contacts of the plug of Figure 40, according to one or more examples of the present disclosure;
Figure 42 is a perspective view of a central engagement element of the plug of Figure 40, according to one or more examples of the present disclosure;
Figure 43 is a perspective view of the flexible electrical contacts of the plug of Figure 40, shown from an interior of an annular flexible circuit board of the plug, according to one or more examples of the present disclosure;
Figure 44 is a side elevation cross-sectional view of a portion of an electrical connector, showing the plug of Figure 40 and a receptacle of the electrical connector coming into engagement, according to one or more examples of the present disclosure;
Figure 45 is a side elevation cross-sectional view of the portion of the electrical connector of Figure 44, showing the plug and the receptacle fully engaged, according to one or more examples of the present disclosure;
Figure 46 is a perspective view of a plug of an electrical connector, shown with a housing of the plug removed, according to one or more examples of the present disclosure;
Figure 47 is a perspective view of a contact assembly for facilitating the attachment of flexible electrical contacts to mounting pads of a flexible circuit board of a plug, according to one or more examples of the present disclosure;
Figure 48 is a perspective view of flexible electrical contacts being mounted to mounting pads of a flexible circuit board of a plug, shown from an underside of the flexible circuit board, according to one or more examples of the present disclosure;
Figure 49 is a perspective view of a plug of an electrical connector, shown with a housing of the plug removed, according to one or more examples of the present disclosure;
Figure 50 is a perspective cross-sectional view of the plug of Figure 49, according to one or more examples of the present disclosure;
Figure 51 is a side elevation cross-sectional view of a portion of an electrical connector, showing the plug of Figure 49 and a receptacle of the electrical connector coming into engagement, according to one or more examples of the present disclosure;
Figure 52 is a side elevation cross-sectional view of the portion of the electrical connector of Figure 51, showing the plug and the receptacle fully engaged, according to one or more examples of the present disclosure; and
Figure 53 is a perspective view of a contact assembly for facilitating the attachment of flexible electrical contacts to mounting pads of a flexible circuit board of a plug, according to one or more examples of the present disclosure.

### DETAILED DESCRIPTION

Reference throughout this specification to "one embodiment," "an embodiment," or similar language means that a particular feature, structure, or characteristic described in connection with the embodiment is included in at least one embodiment of the present disclosure. Appearances of the phrases "in one embodiment," "in an embodiment," and similar language throughout this specification may, but do not necessarily, all refer to the same embodiment. Similarly, the use of the term "implementation" means an implementation having a particular feature, structure, or characteristic described in connection with one or more embodiments of the present disclosure, however, absent an express correlation to indicate otherwise, an implementation may be associated with one or more embodiments.

There is provided an electrical connector including a first connector element and a second connector element. The first connector element includes a first annular flexible circuit board and first electrical contacts coupled to the first annular flexible circuit board in at least one first annular pattern. The second connector element includes a leading end and second electrical contacts. Each one of the second electrical contacts is a flexible electrical contact that includes a fixed portion directly attached to the second annular flexible circuit board and a movable portion that is movable relative to the fixed portion. The movable portion is radially outwardly angled away from the leading end of the second connector element. Each one of the first electrical contacts of the first connector element is in physical contact with a corresponding one of the second electrical contacts of the second connector element.

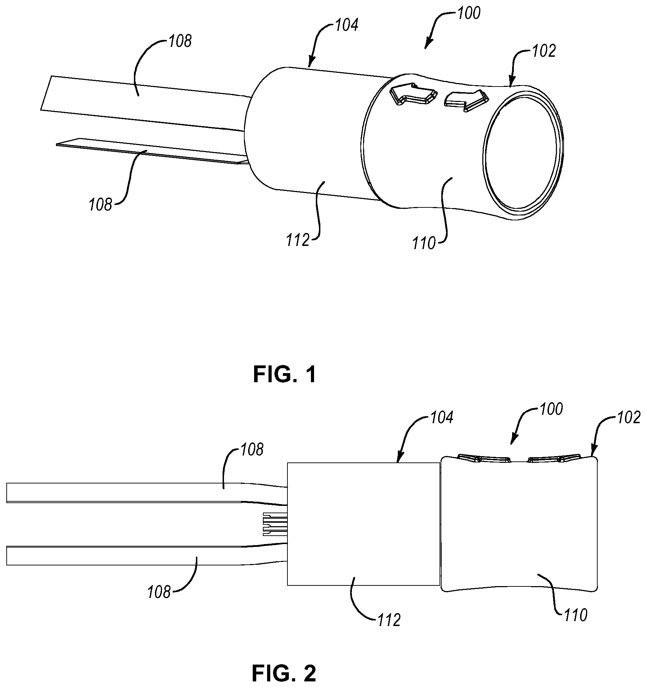

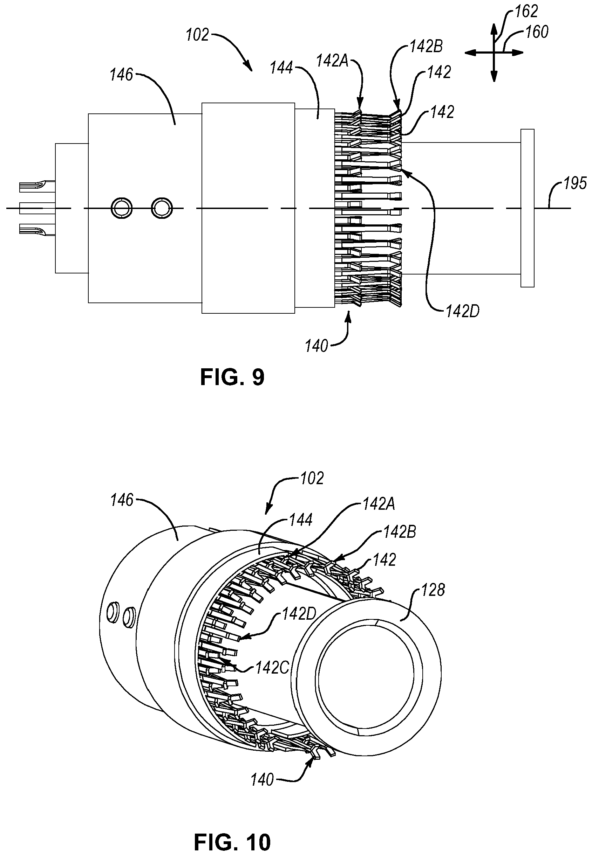

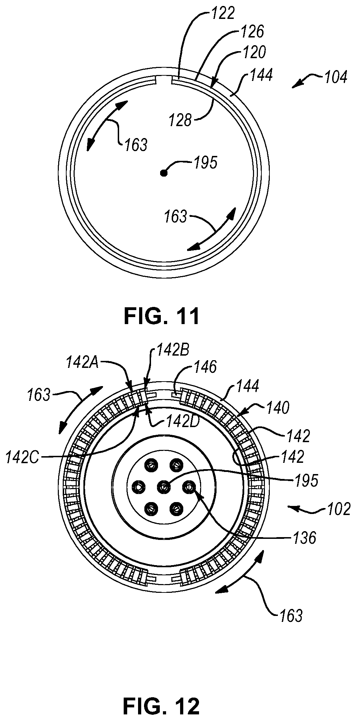

Referring to Figures 1-4, one example of an electrical connector 100 includes a plug 102 and a receptacle 104. The electrical connector 100 is considered a high-density electrical connector because the electrical connector 100 has a high density of electrical contacts or terminals each configured to transmit electrical signals between the plug 102 and the receptacle 104 when connected. Generally, the majority of the electrical contacts of the electrical connector 100 are arranged circumferentially or annularly about a common axis (e.g., central axis 195 of Figures 9, 11-13, and 15). Coaxial and rotational alignment of the plug 102 and the receptacle 104 ensures proper alignment of corresponding electrical contacts of the plug 102 and the receptacle 104. Moreover, coaxial and rotational alignment of the plug 102 and the receptacle 104 is based on initial alignment of a single, predictable primary datum independent of the electrical contacts. Such a configuration is advantageous over conventional high-density electrical connectors with rows of stacked electrical contact boards because any one of the boards may unpredictably act as the primary datum, which may result in a misalignment of or unreliable connections between the other of the boards.

The receptacle 104 includes a housing 112 and circuit boards 108 extending from the housing 112. The circuit boards 108 may include electrical traces imprinted on an electrically-insulating substrate. Moreover, in some implementations, the circuit boards 108 can be flexible circuit boards. Each circuit board 108 is electrically coupled to one or more electrical contacts of the receptacle 104 at one end and other electrical connections (not shown), such as those of a medical tool, device, or system, at an opposite end.

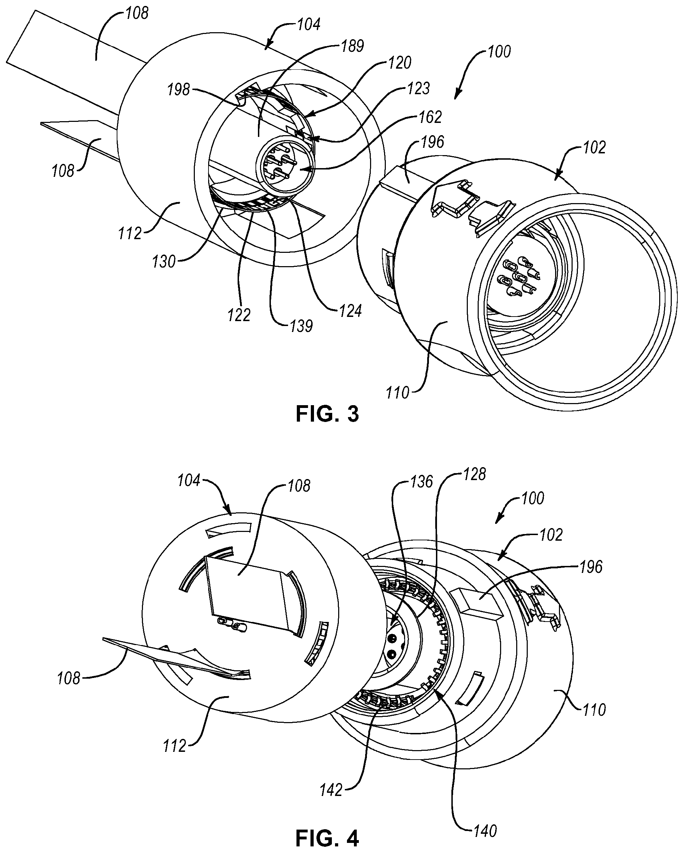

The receptacle 104 further includes an annular flexible circuit board (FCB) 120 housed within an interior cavity of the housing 112. The housing 112 is configured to retain the annular FCB 120 so that the annular FCB 120 does not move relative to the housing 112 and so that an engagement end portion 139 of the annular FCB 120 (see, e.g., Figure 3) is suspended within the interior cavity of the housing 112. As defined herein, the engagement end portion 139 is suspended within the interior cavity when a radially outer surface and a radially inner surface of the engagement end portion 139 are spaced apart from the housing 112 so that a gap is defined between the housing 112 and the radially outer surface and the radially inner surface. This gap enables the flexible electrical contacts 142 of the plug 102 to engage the electrical contact pads 124 from both sides of the annular FCB 120. As defined herein, annular can mean a full or partial ring-like or circular shape.

The annular FCB 120 includes a flexible substrate 122 and electrical contact pads 124 (e.g., electrical contacts) formed on the flexible substrate 122 in a set or sets of annular patterns along a circumference of the flexible substrate 122. In one example, the flexible substrate 122 is initially flat and flexed into an annular or circular shape during assembly of the receptacle 104. The electrical contact pads 124 form an electrical contact-pad interface 123. The electrical contact pads 124 are located on the flexible substrate 122 at the engagement end portion 139 of the annular FCB 120 and are suspended within the interior cavity of the housing 112. The electrical contact pads 124 can be formed on the flexible substrate 122, as surface-mount pads, using any of various deposition techniques, such as printing, etching, masking, and the like. The set of annular patterns of the electrical contact pads 124 are staggered relative to each other as described in more detail below. Each one of the electrical contact pads 124 is electrically coupled with an electrical trace formed in or on the flexible substrate 122. The electrical traces facilitate the transmission of electrical signals between the electrical contact pads 124 and a corresponding one of the circuit boards 108. In some examples, the flexible substrate 122 includes multiple layers and the electrical traces are interposed between layers of the flexible substrate 122. The electrical contact pads 124 (and the corresponding traces) are electrically isolated from each other such that each electrical contact pad 124 facilitates a separate isolated electrical connection.

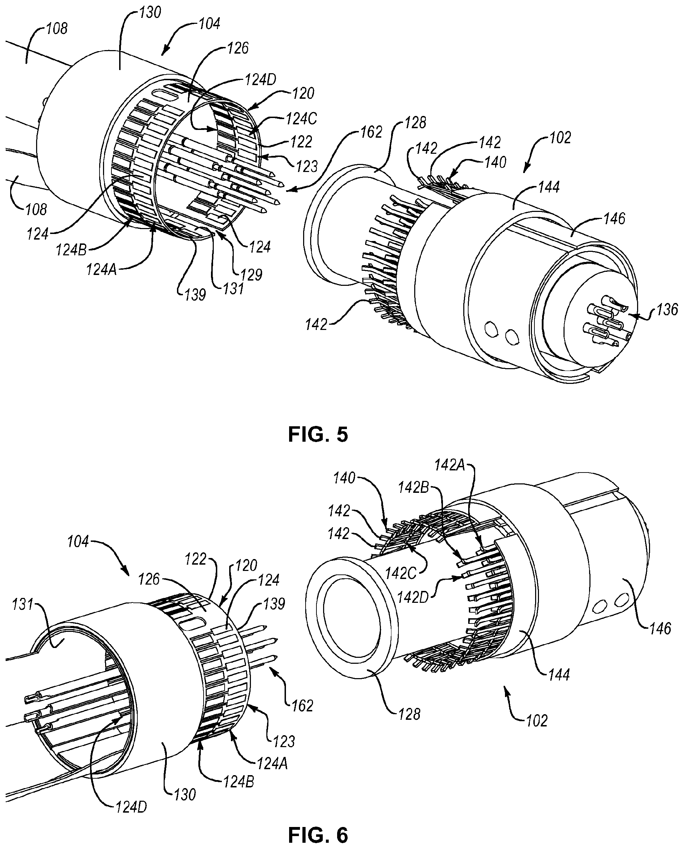

To help retain the annular FCB 120 to the housing 112, in some alternative examples, the receptacle 104 can further include a board retention ring 130 that extends around a distal end portion of the annular FCB 120, opposite the engagement end portion 139, to effectively clamp the annular FCB 120 to the housing 112 or other portion of the receptacle 104 (see, e.g., Figures 5-8). When used, the board retention ring 130 can be formed separately from the housing 112 and is slid over the annular FCB 120 and an interior mounting ring of the housing 112, and forms a friction or interference fit with the annular FCB 120.

The housing 112 additionally includes an annular tube 189 that is concentric with the central axis 195. The annular tube 189 is located radially inwardly and spaced apart from the annular FCB 120. Moreover, the annular tube 189 encircles a central pin interface 162 of the receptacle 104. However, in other embodiments, instead of an annular tube 189, the housing 112 may have a central engagement element that is configured to engage a corresponding engagement element formed in a housing 110 of the plug 102.

The central pin interface 162 is concentric with the central axis 195 and includes a plurality of spaced-apart electrical pins. The electrical pins are positioned within corresponding channels formed in the housing 112. Although not shown, the electrical pins are electrically coupled to other electrical connections (not shown), such as those of a medical tool control system or medical device. The central pin interface 162 can have any number of electrical pins. For example, the central pin interface 162 has eight electrical pins in certain instances. However, in other examples, the central pin interface 162 can have fewer than eight electrical pins (e.g., one to seven electrical pins) or more than eight electrical pins (e.g., twelve, eighteen, or more electrical pins). The electrical pins are made of an electrically conductive material. In one implementation, the electrical pins are configured to transmit electrical power and the electrical contact pads 124 are configured to transmit electrical communication signals.

Although the central pin interface 162 in the illustrated embodiment facilitates electrical connections, in other embodiments, the central pin interface 162 may be modified to facilitate connections of other types, such as fiberoptic, fluidic, pneumatic, and the like. Accordingly, in some implementations, the central pin interface 162 can be interchangeable or reconfigurable to meet any of various interconnect capabilities, such as those demanded by a customer. Furthermore, in some implementations, the central pin interface 162 can be non-removably fixed to or selectively removably coupled to the housing 112.

Additionally, in some implementations, the receptacle 104 includes one or more radio-frequency (RF) or magnetic field signal interference shields configured to block RF interference or noise. For example, the shields can prevent RF or magnetic field signal interference generated by the transmission of electrical power through the electrical pins from interfering with the electrical communication signals transmitted through the electrical contact pads 124. In one implementation, the RF or magnetic field signal interference shields are made of a Mu-metal.

Referring again to Figures 1-4, the plug 102 includes a housing 110 and circuit boards (not shown) extending from the housing 110. The circuit boards, which may be similar to the circuit boards 108, may include electrical traces imprinted on an electrically-insulating substrate. Moreover, in some implementations, the circuit boards can be flexible circuit boards. Each circuit board is electrically coupled to one or more electrical contacts of the plug 102 at one end and other electrical connections (not shown), such as those of a medical tool, device, or system, at an opposite end.

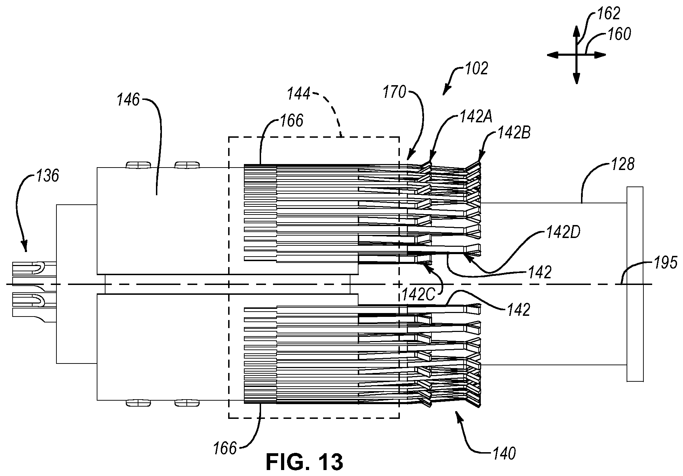

The plug 102 further includes an electrical contact interface 140 that includes flexible electrical contacts 142 arranged in a set of annular patterns corresponding with a set of annular patterns of the electrical contact pads 124 forming the electrical contact-pad interface 123 of the annular FCB 120. Accordingly, the annular patterns of the flexible electrical contacts 142 are staggered relative to each other as described in more detail below. Referring to Figure 13, the flexible electrical contacts 142 are fixed to opposing inner and outer surfaces of an annular FCB 146. The flexible electrical contact 142 includes an elongated arm that extends from a fixed end 166 of the elongated arm to a free end 170 or cantilevered end of the elongated arm. Each one of the flexible electrical contacts 142 is electrically coupled with an electrical trace of the annular FCB 146. The electrical traces facilitate the transmission of electrical signals between the flexible electrical contacts 142 and a corresponding one of circuit boards (not shown) coupled with or forming part of the annular FCB 146. In some examples, the annular FCB 146 includes a flexible substrate having multiple layers and the electrical traces are interposed between the layers. The flexible electrical contacts 142 (and the corresponding traces) are electrically isolated from each other such that each flexible electrical contact 142 facilitates a separate isolated connection. In one example, the annular FCB 146 is initially flat and flexed into an annular or circular shape during assembly of the plug 102. The flexible electrical contacts 142 can be attached to the annular FCB 146 when flat and form the annular patterns when the annular FCB 146 is flexed into the annular shape.

The housing 110 additionally includes a central engagement element 128 that is concentric with the central axis 195. The central engagement element 128 is located radially inwardly and spaced apart from the electrical contact interface 140. Moreover, the central engagement element 128 includes a central receptacle interface 136. The central receptacle interface 136 includes a plurality of spaced-apart electrical pin receptacles. The electrical pin receptacles are positioned within corresponding channels formed in the central receptacle interface 136. Although not shown, the electrical pin receptacles are electrically coupled to other electrical connections, such as those of a medical tool, commercial tool, or other device, at an opposite end. The central receptacle interface 136 can have any number of electrical pin receptacles. For example, the central receptacle interface 136 has eight electrical pin receptacles in some instances. However, in other examples, the central receptacle interface 136 can have fewer than eight electrical pin receptacles (e.g., one to seven electrical pin receptacles) or more than eight electrical pin receptacles (e.g., twelve, eighteen, thirty-two, or more electrical pin receptacles). The electrical pin receptacles are made of an electrically conductive material. In one implementation, the electrical pin receptacles are configured to transmit electrical power and the flexible electrical contacts 142 are configured to transmit electrical communication signals. The number and configuration of the electrical pin receptacles corresponds with that of the electrical pins of the central pin interface 162 so that when the plug 102 is inserted into the receptacle 104, the electric pins are inserted into and mate with the electrical pin receptacles to establish an electrical connection therebetween.

In some examples the central pin interface 162 includes tubular sleeves and each one of the electrical pins is partially enveloped by a corresponding one of the sleeves. The portions of the pins not enveloped by the sleeves extend from the sleeves and are electrically connected to the electrical pin receptacles of the central receptacle interface 136. The channels of the central receptacle interface 136 can be sized to receive (e.g., nestably receive) at least a portion of the sleeves so that both the sleeves and the pins extend into the channels of the central receptacle interface 136. The sleeves are made of an electrically non-conductive material, such as plastic. The sleeves of the central pin interface 162, being nestably received within the channels of the central receptacle interface 136, help to provide a longer insulation path when mated.

Although the central receptacle interface 136 in the illustrated embodiment facilitates electrical connections, in other embodiments, the central receptacle interface 136 may be modified to facilitate connections of other types, such as fiberoptic, fluidic, pneumatic, and the like. Accordingly, in some implementations, the central receptacle interface 136 can be interchangeable or reconfigurable to meet any of various interconnect capabilities, such as those demanded by a customer. Furthermore, in some implementations, the central receptacle interface 136 can be non-removably fixed to or selectively removably coupled to the housing 110.

Additionally, in some implementations, the plug 102 includes one or more radio-frequency (RF) or magnetic field signal interference shields configured to block RF interference, magnetic field signals, and/or noise. For example, the shields can prevent RF interference or magnetic field signals generated by the transmission of electrical power through the electrical pins from interfering with the electrical communication signals transmitted through the flexible electrical contacts 142. In one implementation, the RF or magnetic field signal interference shields are made of a Mu-metal.

It is recognized that, in alternative examples, the plug 102 includes the electrical pins 164 and the receptacle 104 includes the electrical pin receptacles.

The plug 102 can be releasably connected to the receptacle 104 via a passive latch mechanism comprising retention tabs and recesses. However, in other examples, the plug 102 is releasably connected to the receptacle 104 via other coupling mechanisms, such as active latch mechanisms, friction latch mechanisms, and the like.

Referring to Figures 5-8 and 11, more details of the annular FCB 120 of the receptacle 104 are shown. The flexible substrate 122 of the annular FCB 120 has a thickness, which extends in a radial direction relative to the central axis 195, a width, which extends in a circumferential direction 163 perpendicular to the radial direction, and a length, which extends in a longitudinal direction 160 (i.e., axial direction) that is parallel to the central axis 195. The width is equal to the full or partial circumference of the circular shape defined by the flexible substrate 122. In some examples, the width of the flexible substrate 122 is less than the full circumference of the circular shape defined by the flexible substrate 122, such that a gap 129 is defined between opposing ends of the flexible substrate 122. However, in other examples, the width of the flexible substrate 122 is equal to the circumference of the circular shape defined by the flexible substrate 122, such that the opposing ends of the flexible substrate 122 are connected (e.g., adhered or soldered together) and no gap is present between the opposing ends. The flexible substrate 122 includes two opposing broad-faced surfaces. For example, the flexible substrate 122 has an outer surface 126 and an inner surface 131, which face opposite directions. The outer surface 126 faces away from the central axis 195 and the inner surface 131 faces towards the central axis 195. Both the outer surface 126 and the inner surface 131 are contoured or curved. The outer surface 126 has a convex contour and the inner surface 128 has a concave contour.

In some examples, the electrical contact pads 124 are formed on both the outer surface 126 and the inner surface 131 to maximize the number of electrical connections enabled by the electrical connector 100. Moreover, the electrical contact pads 124 of the electric contact-pad interface 123 are grouped into different annular pad patterns extending circumferentially along the width of the flexible substrate 122. Each one of the annular pad patterns includes an annular arrangement of electrical contact pads 124 spaced apart from each other in the circumferential direction 163 along the width of the flexible substrate 122. The electrical contact pads 124 of a given annular pad pattern are circumferentially aligned (i.e., located the same distance from the end of the engagement end portion 139 in the longitudinal direction 160). However, in certain examples, the electrical contact pads 124 of a pad pattern on a given surface of the flexible substrate are longitudinally offset (e.g., spaced apart axially) from the electrical contact pads 124 of any other pad pattern on the given surface. In other words, no electrical contact pads 124 of one pad pattern on a given surface overlap with, in the circumferential direction 163, any of the electrical contact pads 124 of any other pad pattern on the given surface. Additionally, the electrical contact pads 124 of a given annular pad pattern have the same size and shape in some examples.

In the illustrated example, the electrical contact pads 124 are grouped into a first pad pattern 124A, a second pad pattern 124B, a third pad pattern 124C, and a fourth pad pattern 124D. The first pad pattern 124A and the second pad pattern 124B are formed on the outer surface 126. Similarly, the third pad pattern 124C and the fourth pad pattern 124D are formed on the inner surface 131. The electrical contact pads 124 of the first pad pattern 124A are situated closer to the end of the engagement end portion 139 than the second pad pattern 124B. Likewise, the electrical contact pads 124 of the third pad pattern 124C are situated closer to the end of the engagement end portion 139 than the fourth pad pattern 124D.

Adjacent pad patterns on a given surface of the flexible substrate 122 are staggered. More specifically, the electrical contact pads 124 of one pad pattern on a given surface of the flexible substrate 122 are staggered relative to the electrical contact pads 124 of an adjacent pad pattern on the given surface. As defined herein, a pad pattern on a given surface is staggered relative to an adjacent pad pattern on the given surface when each one of the electrical contact pads 124 of the pad pattern is not aligned with, in the longitudinal direction 160, any one of the electrical contact pads 124 of the adjacent pad pattern. Alignment of two electrical contact pads in a given direction means a center (i.e., a midpoint of the electrical contact pad in a direction perpendicular to the given direction) of one of the two electrical contact pads is in the same plane as a center of the other one of the two electrical contact pads, where the plane is parallel with the given direction. In one example of adjacent pad patterns that are staggered, each one of the electrical contact pads 124 of one pad pattern on a given surface is aligned, in the longitudinal direction 160, with a gap or space between a corresponding two electrical contact pads 124 of the other pad pattern.

Although two pad patterns on each side of the flexible substrate 122 are shown, it is recognized that in some examples, the receptacle 104 can have more than two pad patterns (e.g., three or more pad patterns) on the same side or both sides of the flexible substrate 122. In such examples, although adjacent ones of the pad patterns are staggered relative to each other, non-adjacent ones of the pad patterns may not be staggered relative to each other. For example, on a given side of the flexible substrate 122, the electrical contact pads 124 of a first pad pattern can be longitudinally aligned with the electrical contact pads 124 of a third pad pattern and not longitudinally aligned with the electrical contact pads 124 of a second pad pattern between the first and third pad patterns. In this example, the first and second pad patterns are staggered relative to each other and the second and third pad patterns are staggered relative to each other. Accordingly, the receptacle 104 is considered to have staggered pad patterns, even if some of the pad patterns are not staggered relative to each other, as long as directly adjacent ones of the pad patterns are staggered. In the case of a receptacle 104 having four pad patterns on the same side of the flexible substrate 122, the four pad patterns can be divided into two sets of staggered pad patterns where a pad pattern of one of the two sets may not be staggered relative to a pad pattern of the other of the two sets.

In the illustrated examples, the first pad pattern 124A is staggered relative to the second pad pattern 124B (collective forming a set of patterns), and the third pad pattern 124C is staggered relative to the fourth pad pattern 124D (collectively forming a set of patterns). In conjunction with the above descriptions, this means the electrical contact pads 124 of the first pad pattern 124A are longitudinally offset relative to the electrical contact pads 124 of the second pad pattern 124B, and no one of the electrical contact pads 124 of the first pad pattern 124A is aligned with, in the longitudinal direction 160, any one of the electrical contact pads 124 of the second pad pattern 124B. Similarly, the above description means the electrical contact pads 124 of the third pad pattern 124C are longitudinally offset relative to the electrical contact pads 124 of the fourth pad pattern 124D, and no one of the electrical contact pads 124 of the third pad pattern 124C is aligned with, in the longitudinal direction 160, any one of the electrical contact pads 124 of the fourth pad pattern 124D.

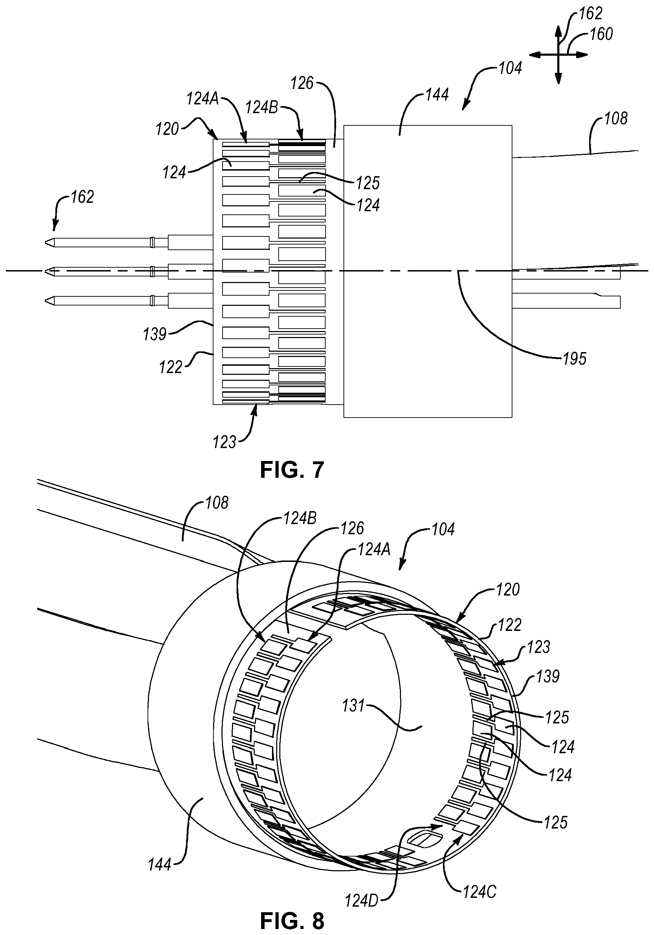

In certain examples, such as shown, the electrical contact pads 124 of one of the pad patterns on a given surface are electrically coupled with an electrical trace 125 that is formed on the given surface and longitudinally (e.g., parallel with the central axis 195) extend through the gaps between adjacent ones of the electrical contact pads 124 of the adjacent one of the pad patterns on the given surface. For example, as shown in Figure 7, each one of the electrical contact pads 124 of the first pad pattern 124A is electrically coupled with a surface-mounted electrical trace 125 that extends longitudinally along the outer surface 126 between two of the electrical contact pads 124 of the second pad pattern 124B. As shown in Figure 8, the electrical contact pads 124 of the third pad pattern 124C are coupled with electrical traces 125 in the same manner as the first pad pattern 124A.

Referring to Figures 5, 6, 9, 10, 12, and 13, more details of the electrical contact interface 140 of the plug 102 are shown. The annular FCB 146 of the plug 102 has an outer surface and an inner surface, which face opposite directions. The outer surface faces away from the central axis 195 and the inner surface faces towards the central axis 195. Both the outer surface and the inner surface of the annular FCB 146 are contoured or curved, such that the outer surface has a convex contour and the inner surface has a concave contour. In some examples, the flexible electrical contacts 142 of the electrical contact interface 140 are attached to both the outer surface and the inner surface of the annular FCB 146 to maximize the number of electrical connections enabled by the electrical connector 100. Moreover, the flexible electrical contacts 142 are grouped into different annular contact patterns extending circumferentially along the width of the annular FCB 146.

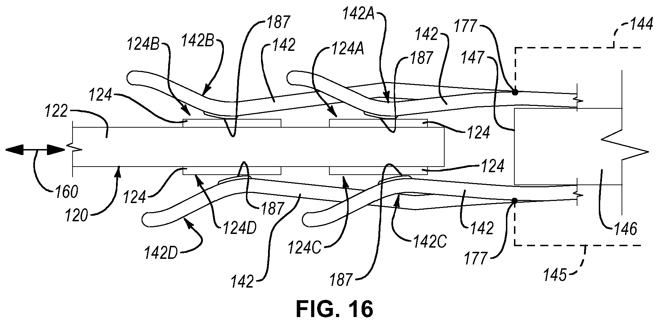

Each one of the annular contact patterns includes an annular arrangement of electrical contact points 187 (see, e.g., Figure 16) of the flexible electrical contacts 142, which are spaced apart from each other in the circumferential direction 163 so that a gap is defined between the flexible electrical contacts 142 defining a given annular contact pattern. In examples that have two annular contact patterns on a given side of the annular FCB 146, such as shown, the flexible electrical contacts 142 defining one of the two annular contact patterns are positioned in the gaps defined between the flexible electrical contacts 142 defining the other one of the two annular contact patterns. In other words, on a given side of the annular FCB 146, the flexible electrical contacts 142 defining one of the two annular contact patterns on that side are interposed between the flexible electrical contacts 142 defining the other one of the two annular contact patterns on the same side. The size of the gaps are such that the flexible electrical contacts 142 defining one of the two annular contact patterns are electrically isolated from the flexible electrical contacts 142 defining the other one of the two annular contact patterns on the same side.

The electrical contact points 187 of a given annular pad pattern are circumferentially aligned (i.e., located the same distance from the end 147 of the annular FCB 146). However, in certain examples, the electrical contact points 187 of the flexible electrical contacts 142 of a contact pattern on a given side of the annular FCB 146 are longitudinally offset from the electrical contact points 187 of the flexible electrical contacts 142 of any other contact pattern on the given side. In other words, no electrical contact points 187 of one contact pattern on a given side overlap with, in the circumferential direction 163, any of the electrical contact points 187 of any other contact pattern on the given side.

In the illustrated example, the flexible electrical contacts 142 are grouped into a first contact pattern 142A, a second contact pattern 142B, a third contact pattern 142C, and a fourth contact pattern 142D. The first contact pattern 142A and the second contact pattern 142B are attached to the outer surface of the annular FCB 146. Similarly, the third contact pattern 142C and the fourth contact pattern 142D are formed on the inner surface of the annular FCB 146. The electrical contact points 187 of the first contact pattern 142A are situated closer to the end 147 of the annular FCB 146 than the electrical contact points 187 of the second contact pattern 142B. Likewise, the electrical contact points 187 of the third contact pattern 142C are situated closer to the end 147 of the annular FCB 146 than the fourth contact pattern 142D.

The contact patterns of the flexible electrical contacts 142 on a given surface of the annular FCB 146 are staggered. More specifically, the electrical contact points 187 of one contact pattern on a given surface of the annular FCB 146 are staggered relative to the electrical contact points 187 of an adjacent contact pattern on the given surface. As defined herein, a contact pattern of flexible electrical contacts 142 on a given surface is staggered relative to an adjacent contact pattern of flexible electrical contacts 142 on the given surface when the electrical contact points 187 of all the flexible electrical contacts 142 of the contact pattern are not aligned with, in the circumferential direction 163, any one of the electrical contact points 187 of the adjacent contact pattern. Alignment of two electrical contact points in the circumferential direction 163 means a center (i.e., a midpoint of the electrical contact pad in a direction perpendicular to the circumferential direction 163) of one of the two electrical contact points is in the same plane as a center of the other one of the two electrical contact points, where the plane is parallel with the circumferential direction 163.

Although two contact patterns are shown on each side of the annular FCB 146, it is recognized that in some examples, the plug 102 can have more than two contact patterns (e.g., three or more contact patterns) on the same side or both sides of the annular FCB 146. In such examples, although adjacent ones of the contact patterns are staggered relative to each other, non-adjacent ones of the contact patterns may not be staggered relative to each other. For example, on a given side of the annular FCB 146, the electrical contact points 187 of a first contact pattern can be longitudinally aligned with the electrical contact points 187 of a third contact pattern and not longitudinally aligned with the electrical contact points 187 of a second contact pattern between the first and third contact patterns. In this example, the first and second contact patterns are staggered relative to each other and the second and third contact patterns are staggered relative to each other. Accordingly, the plug 102 is considered to have staggered contact patterns, even if some of the contact patterns are not staggered relative to each other, as long as directly adjacent ones of the contact patterns are staggered. In the case of a plug 102 having four contact patterns on the same side of the annular FCB 146, the four contact patterns can be divided into two sets of staggered contact patterns where a contact pattern of one of the two sets may not be staggered relative to a contact pattern of the other of the two sets.

In the illustrated examples, the first contact pattern 142A is staggered relative to the second contact pattern 142B (collectively forming a set of patterns), and the third contact pattern 142C is staggered relative to the fourth contact pattern 142D (collectively forming a set of patterns). This means the electrical contact points 187 of the first contact pattern 142A are longitudinally offset relative to the electrical contact points 187 of the second contact pattern 142B, and the electrical contact points 187 of the third contact pattern 142C are longitudinally offset relative to the electrical contact points 187 of the fourth contact pattern 142D.

Generally, the electrical contact points 187 are proximate a cantilevered end of the flexible electrical contacts 142. Accordingly, the flexible electrical contacts 142 defining the first contact pattern 142A are shorter than the flexible electrical contacts 142 defining the second contact pattern 142B. Likewise, the flexible electrical contacts 142 defining the third contact pattern 142C are shorter than the flexible electrical contacts 142 defining the fourth contact pattern 142D.

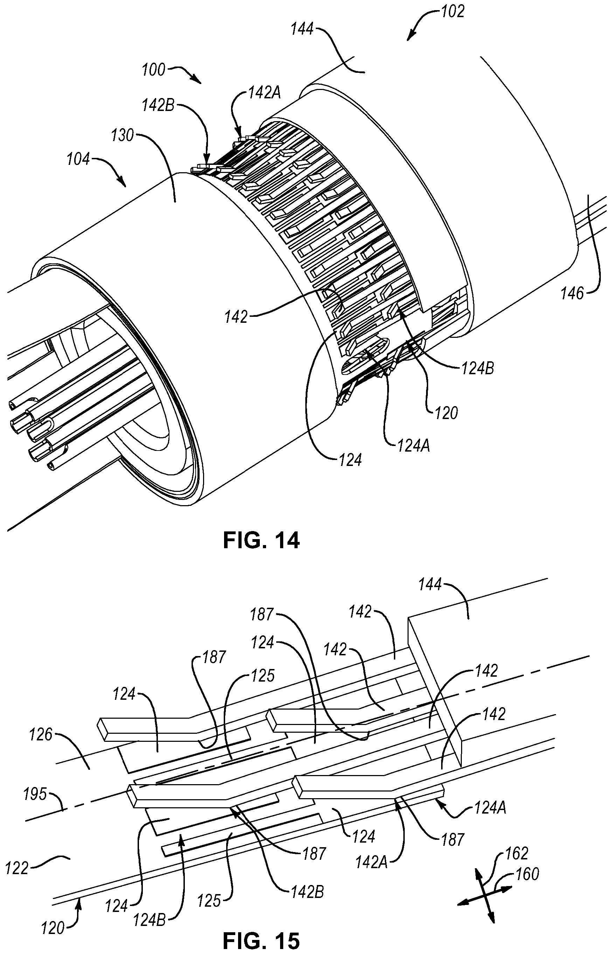

Referring to Figures 14-16, with the central axis 195 of the plug 102 aligned with the central axis 195 of the receptacle 104, the plug 102 can be inserted into the receptacle 104. As the plug 102 is inserted into the receptacle 104, the flexible electrical contacts 142 engage the electrical contact pads 124 and establish an electrical connection with the electrical contact pads 124. Engagement includes radial flexing (i.e., flexing in a radial direction) of the flexible electrical contacts 142 and sliding of the electrical contact points 187 along the flexible substrate 122 until the electrical contact points 187 come into contact with corresponding ones of the electrical contact pads 124. To facilitate initial engagement with the flexible substrate 122 and initial radial flexing of the flexible electrical contacts 142, the cantilevered ends of the flexible electrical contacts 142 can be angled, beveled, or sloped. In some examples, the plug 102 includes separator prongs that extend between circumferentially adjacent flexible electrical contacts 142. The separator prongs are more rigid than the flexible electrical contacts 142. Accordingly, the separator prongs help to maintain separation between circumferentially adjacent flexible electrical contacts 142, and help to prevent radially adjacent flexible electrical contacts 142 from scissoring relative to each other.

To promote rotational alignment of the plug 102 and the receptacle 104 relative to each other, in some examples, as shown in Figure 4, the plug 102 and the receptacle 104 can include keying features that, when engaged, ensure proper rotational alignment of the plug 102 and the receptacle 104. For example, the housing 110 of the plug 102 can include a first keying feature 196 and the housing 112 of the receptacle 104 can include a second keying feature 198. In order for full insertion of the plug 102 into the receptacle 104, the first keying feature 196 must be engaged with the second keying feature 198. In the illustrated example, the first keying feature 196 is a rib or tab, and the second keying feature 198 is a slot or channel within which the rib or tab is slidable. However, it is recognized that in other examples, the first keying feature 196 is a slot or channel, and the second keying feature 198 is a rib or tab. Additionally, or alternatively, first and second keying features could be integrated into the annular tube 189 of the housing 112 and the central engagement element 128 of the housing 110, respectively.

In the illustrated examples, the flexible electrical contacts 142 of the first contact pattern 142A flex radially outwardly away from the central axis 195 so that the electrical contact point 187 of each one of the flexible electrical contacts 142 of the first contact pattern 142A makes electrical contact with a corresponding one of the electrical contact pads 124 of the first pad pattern 124A. Similarly, the flexible electrical contacts 142 of the second contact pattern 142B flex radially outwardly away from the central axis 195 so that the electrical contact point 187 of each one of the flexible electrical contacts 142 of the second contact pattern 142B makes electrical contact with a corresponding one of the electrical contact pads 124 of the second pad pattern 124B. In contrast to the foregoing, the flexible electrical contacts 142 of the third contact pattern 142C flex radially inwardly toward the central axis 195 so that the electrical contact point 187 of each one of the flexible electrical contacts 142 of the third contact pattern 142C makes electrical contact with a corresponding one of the electrical contact pads 124 of the third pad pattern 124C. Likewise, the flexible electrical contacts 142 of the fourth contact pattern 142D flex radially inwardly toward the central axis 195 so that the electrical contact point 187 of each one of the flexible electrical contacts 142 of the fourth contact pattern 142D makes electrical contact with a corresponding one of the electrical contact pads 124 of the fourth pad pattern 124D.

The flexible electrical contacts 142 radially flexes about a contraflexure point. The further the distance from an electrical contact point 187 and the contraflexure point the smaller the force applied by the electrical contact point 187 to an electrical contact pad 124, and thus the weaker the electrical contact between the electrical contact point 187 and the electrical contact pad 124. To improve the electrical contact, the contraflexure point can be moved closer to the electrical contact point 187. In some examples, and with reference to Figures 13 and 14, the plug 102 includes a contraflexure adjustment ring 144 that encircles the flexible electrical contacts 142 of the first contact pattern 142A and the second contact pattern 142B and sets a contraflexure point 177 (see, e.g., Figure 16) that is closer to the electrical contact points 187, compared to without the contraflexure adjustment ring 144 when the contraflexure point would be near the attachment point of the flexible electrical contacts 142 to the annular FCB 146. The plug 102 further includes a second contraflexure adjustment ring 145 located radially inwardly of the contraflexure adjustment ring 144 so that the annular FCB 146 is between the contraflexure adjustment rings. The second contraflexure adjustment ring 145 extends along the flexible electrical contacts 142 of the third contact pattern 142C and the fourth contact pattern 142D and sets a contraflexure point 177 that is closer to the electrical contact points 187.

The electrical contact pads 124 and the flexible electrical contacts 142 are made of an electrically conductive material, such as metal (e.g., copper, phosphorus-bronze, beryllium-copper, or other electrically conductive spring alloys). In some examples, the flexible electrical contacts 142 are made using a metal stamping process. For example, each flexible electrical contact 142 can be formed by stamping without a subsequent bending of the flexible electrical contact 142. In other words, no portion of the flexible electrical contact 142 is elastically deformed. Because bending of the flexible electrical contact 142 is not necessary, each one of the flexible electrical contacts 142 can be smaller and formed at a lower cost, with a more fine-tuned moment of inertia, and with more controlled tolerances compared to stamped and bent electrical contacts.

Although the illustrated examples of the electrical connector 100 include staggered electrical contact pads 124 on outer and inner surfaces of an annular FCB of a receptacle and staggered flexible electrical contacts 142 on outer and inner surfaces of an annular FCB of a plug, it is recognized in other examples, only one of the outer and inner surfaces of the annular FCB of the receptacle includes staggered electrical contact pads and only one of the outer and inner surfaces of the annular FCB of the plug includes staggered flexible electrical contacts. Additionally, it is recognized that in some embodiments the electrical connection features of the electrical connector 100 can be reversed without departing from the essence of the present disclosure. For example, the receptacle can include staggered flexible electrical contacts and the plug can include staggered electrical contact pads.

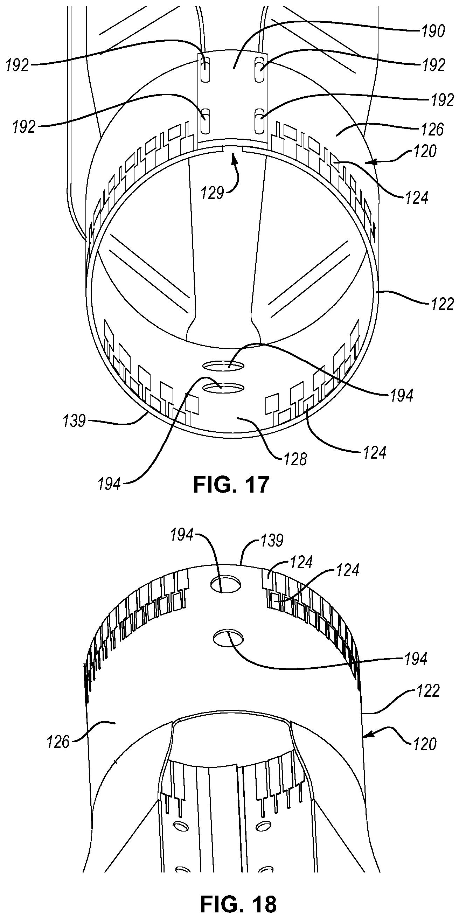

Referring to Figure 17, in some examples, the receptacle 104 includes a FCB retention bracket 190 that is coupled to the annular FCB 120 and spans the gap 129 between opposing ends of the annular FCB 120. The FCB retention bracket 190 helps to fix the position of the opposing ends relative to each other, and thus improves the hoop strength of the annular FCB 120 and maintains the circular shape of the annular FCB 120 around a mandrel portion or cylindrical mounting portion of the housing 112. The FCB retention bracket 190 has a curvature similar to the curvature of the annular FCB 120. In certain examples, the FCB retention bracket 190 is made of a material different than the flexible substrate 122 of the annular FCB 120. For example, the substrate 122 can be made of a non-metal and the FCB retention bracket 190 can be made of a metal. According to some examples, the FCB retention bracket 190 is adhered to, soldered to, or welded to the annular FCB 120. The annular FCB 120 can include solder pads 192 at location near the opposing ends of the annular FCB 120, which facilitate the soldering of the FCB retention bracket 190 to the annular FCB 120. In the illustrated example, the annular FCB 120 includes two solder pads 192, spaced apart along one of the opposing edges, and two solder pads 192, spaced apart along the other one of the opposing edges. To help strengthen the solder pads 192, and the overall coupling between the FCB retention bracket 190 and the annular FCB 120, the solder pads 192 can include via portions that extend through a thickness of the flexible substrate 122 of the annular FCB 120.

As shown in Figure 18, in certain examples, the annular FCB 120 includes registration features, such as registration apertures 194, located further away from the edge of the engagement end portion 139 than the electrical contact pads 124. The housing 112 includes corresponding registration features, such as tabs or protrusions, that engage the registration features of the annular FCB 120. Engagement between the registration features of the annular FCB 120 and the housing 112 maintains the shape of the annular FCB 120 away from the engagement end portion 139, which helps to prevent buckling of annular FCB 120 away from the engagement end portion 139.

In the above examples of the electrical connector 100, the electrical contact pads 124 of the flexible substrate 122 are staggered. However, in alternative examples, as described below, an electrical connector 200, similar to the electrical connector 100, includes a flexible substrate 222 where electrical contact pads 224 of the flexible substrate 222 are not staggered.

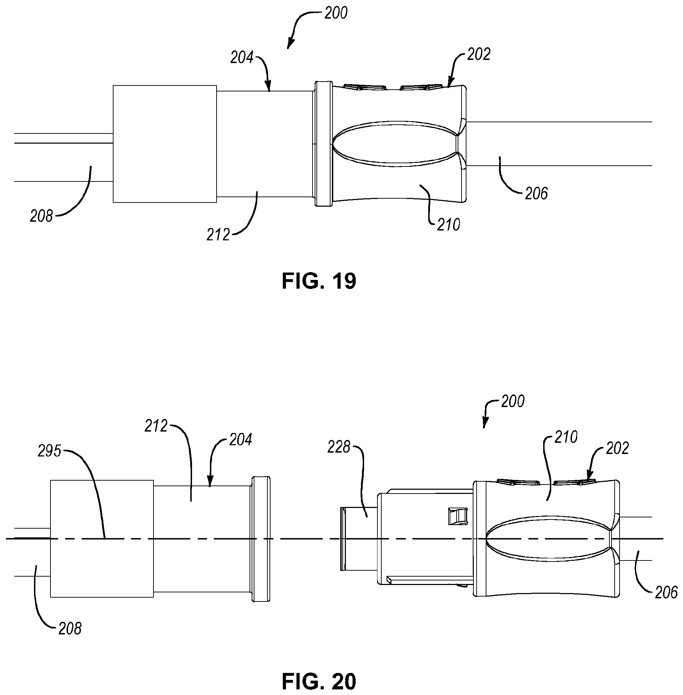

Referring to Figures 19-22, one example of the electrical connector 200 includes a plug 202 and a receptacle 204. Like the electrical connector 100, the electrical connector 200 is considered a high-density electrical connector. Again, like the electrical connector 100, the majority of the electrical contacts of the electrical connector 200 are arranged circumferentially or annularly about a common axis (e.g., central axis 295 of Figures 9, 11-13, and 15). Accordingly, like the electrical connector 100, coaxial and rotational alignment of the plug 202 and the receptacle 204 is based on initial alignment of a single, predictable primary datum independent of the electrical contacts.

The receptacle 204 includes a housing 212 and circuit boards 208 extending from the housing 212. The circuit boards 208 may include electrical traces imprinted on an electrically-insulating substrate. Moreover, in some implementations, the circuit boards 208 can be flexible circuit boards. Each circuit board 206 is electrically coupled to one or more electrical contacts of the receptacle 204 at one end and other electrical connections (not shown), such as those of a medical tool, device, or system, at an opposite end.

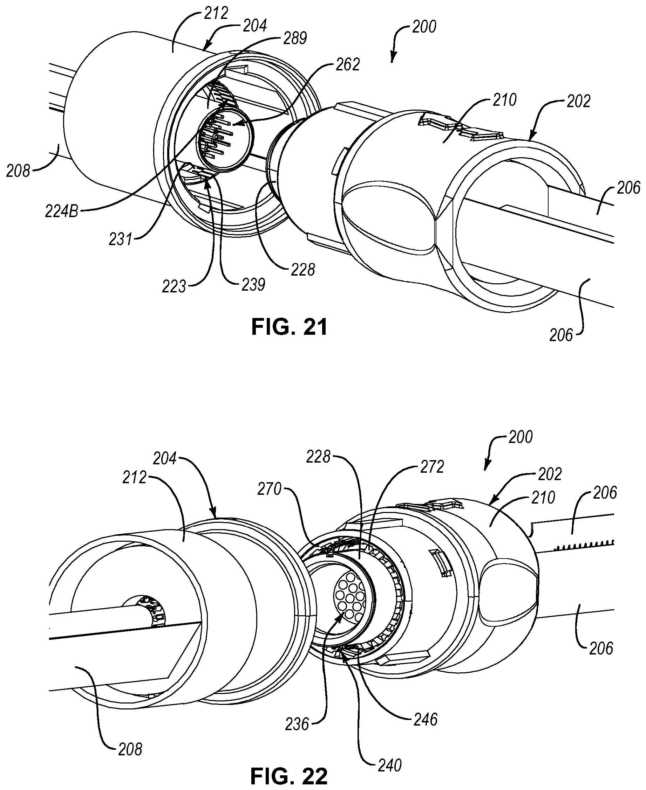

The receptacle 204 further includes an annular FCB 220 housed within an interior cavity of the housing 212. The receptacle 204 further includes a frame 289 within and retained by the housing 212. Although shown as two pieces, in some examples, the frame 289 and the housing 212 can be co-formed together. The frame 289, which includes a central annular tube, is configured to retain the annular FCB 220 so that the annular FCB 220 does not move relative to the housing 212 and so that an engagement end portion 239 of the annular FCB 220 (see, e.g., Figures 21 and 32-34) is suspended within the interior cavity of the housing 212, as defined above. Suspending the engagement end portion 239 within the housing 212 enables flexible electrical contacts 242 of the plug 102 to engage the electrical contact pads 224 from both sides of the annular FCB 220.

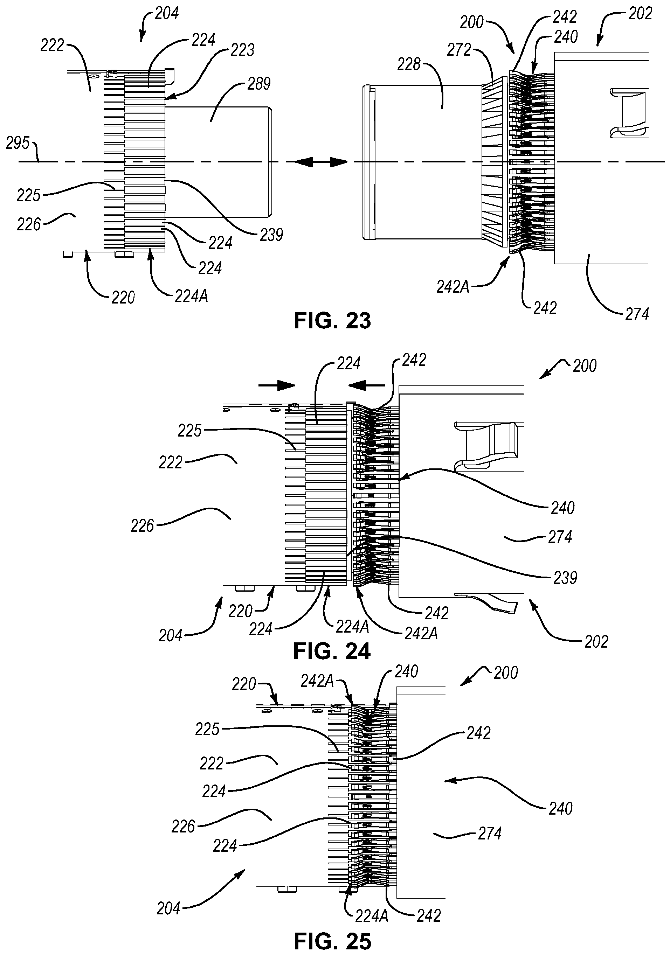

Referring to Figures 23-25, the annular FCB 220 includes a flexible substrate 222 and the electrical contact pads 224, which are formed on the flexible substrate 222 in annular patterns along a circumference (e.g., circumferential edge) of the flexible substrate 222. In one example, the flexible substrate 222 is initially flat and flexed into an annular or circular shape during assembly of the receptacle 204. The electrical contact pads 224 form an electrical contact-pad interface 223. The electrical contact pads 224 are located on the substrate 222 at the engagement end portion 239 of the annular FCB 220 and thus are suspended within the interior cavity of the housing 212. The electrical contact pads 224 can be formed on the flexible substrate 222 using any of various techniques, such as those described above in association with the receptacle 104. The electrical contact pads 224 on each side of the flexible substrate 222 are circumferentially non-staggered (i.e., circumferentially aligned) relative to each other, as described in more detail below. Each one of the electrical contact pads 224 is electrically coupled with an electrical trace 225 formed in or on the substrate 222. The electrical traces 225 facilitate the transmission of electrical signals between the electrical contact pads 224 and a corresponding one of the circuit boards 208. In some examples, the flexible substrate 222 includes multiple layers and the electrical traces are interposed between layers of the flexible substrate 222. The electrical contact pads 224 (and the corresponding traces) are electrically isolated from each other such that each electrical contact pad 224 facilitates a separate isolated electrical connection. The annular FCB 220 can be retained within the housing 212 in a manner similar to how the annular FCB 120 is retained within the housing 112.

The frame 289 additionally includes an annular tube that is concentric with the central axis 295. The annular tube of the frame 289 is located radially inwardly and spaced apart from the annular FCB 220. Moreover, the annular tube encircles a central pin interface 262 of the receptacle 204. However, in other embodiments, instead of an annular tube, the frame 289 may have a central engagement element that is configured to engage a corresponding engagement element formed in a housing 210 of the plug 202, which can have an outer portion 274 (see, e.g., Figures 23-25). The central pin interface 262 is concentric with the central axis 295 and includes a plurality of spaced-apart electrical pins, which can be configured in a manner similar to that described above in relation to the central pin interface 162.

Additionally, in some implementations, the receptacle 204 includes one or more radio-frequency (RF) or magnetic field signal interference shields configured to block RF interference or noise. For example, the shields can prevent RF or magnetic field signal interference generated by the transmission of electrical power through the electrical pins from interfering with the electrical communication signals transmitted through the electrical contact pads 224. In one implementation, the RF or magnetic field signal interference shields of the receptacle 204 are made of a Mu-metal.

Referring again to Figures 19-22, the plug 202 includes a housing 210 and circuit boards 206 extending from the housing 210. The circuit boards 206 may include electrical traces imprinted on an electrically-insulating substrate. Moreover, in some implementations, the circuit boards 206 can be flexible circuit boards. Each circuit board 206 is electrically coupled to one or more electrical contacts of the plug 202 at one end and other electrical connections (not shown), such as those of a medical tool, device, or system, at an opposite end.

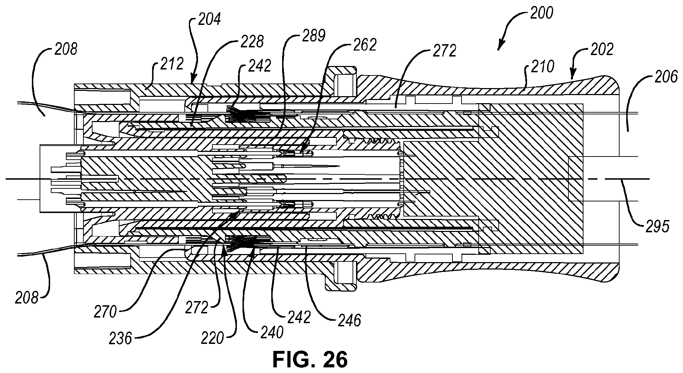

The plug 202 further includes an electrical contact interface 240 that includes flexible electrical contacts 242 arranged in annular patterns corresponding with the annular patterns of the electrical contact pads 224 forming the electrical contact-pad interface 223 of the annular FCB 220. Referring to Figures 26 and 32-37, the flexible electrical contacts 242 are fixed to contact pads on opposing inner and outer surfaces of a flexible substrate 249 of an annular FCB 246. Each one of the flexible electrical contacts 242 is electrically coupled with an electrical trace of the annular FCB 246 via the corresponding contact pads. The electrical traces facilitate the transmission of electrical signals between the flexible electrical contacts 242 and a corresponding one of the circuit boards 206. In some examples, the flexible substrate 249 has multiple layers and the electrical traces are interposed between the layers. The flexible electrical contacts 242 (and the corresponding traces) are electrically isolated from each other such that each flexible electrical contact 242 facilitates a separate isolated connection. In one example, the annular FCB 246 is initially flat and flexed into an annular or circular shape during assembly of the plug 202. The flexible electrical contacts 242 can be attached to the annular FCB 246 when flat and form the annular patterns when the annular FCB 246 is flexed into the annular shape. In the illustrated examples, the width of the flexible substrate 249 is greater than the circumference of the circular shape defined by the flexible substrate 249, such that opposing ends of the flexible substrate 249 are connected (e.g., adhered, soldered, and/or fastened together) at overlapping portions of the opposing ends, as described in more detail below.

The housing 210 additionally includes a central engagement element 228 that is concentric with the central axis 295. The central engagement element 228 is located radially inwardly and spaced apart from the electrical contact interface 240. Moreover, the central engagement element 228 includes a central receptacle interface 236. The central receptacle interface 236 is concentric with the central axis 295 and includes a plurality of spaced-apart electrical pin receptacles, which can be configured in a manner similar to that described above in relation to the central receptacle interface 136. The number and configuration of the electrical pin receptacles corresponds with that of the electrical pins of the receptacle 204 so that when the plug 202 is inserted into the receptacle 204, the electric pins are inserted into and mate with the electrical pin receptacles to establish an electrical connection therebetween. It is recognized that, in alternative examples, the plug 202 includes the electrical pins and the receptacle 204 includes the electrical pin receptacles.

In some implementations, the plug 202 includes one or more radio-frequency (RF) or magnetic field signal interference shields configured to block RF interference or noise. For example, the shields can prevent RF or magnetic field signal interference generated by the transmission of electrical power through the electrical receptacles from interfering with the electrical communication signals transmitted through the flexible electrical contacts 242. In one implementation, the RF or magnetic field signal interference shields of the plug 202 are made of a Mu-metal.

The plug 202 can be releasably connected to the receptacle 204 via any of various coupling mechanisms, such as active latch mechanisms, friction latch mechanisms, and the like.

Referring to Figures 23-25, 36, and 37, more details of the annular FCB 220 of the receptacle 204 are shown. The flexible substrate 222 of the annular FCB 220 has a thickness, a width, and a length, which are defined in the same manner as the thickness, the width, and the length of the flexible substrate 122 of the annular FCB 120. In the illustrated examples, the width of the flexible substrate 222 is greater than the circumference of the circular shape defined by the flexible substrate 222, such that opposing ends of the flexible substrate 222 are connected (e.g., adhered, soldered, and/or fastened together) at overlapping portions of the opposing ends, as described in more detail below. The flexible substrate 222 includes two opposing broad-faced surfaces, including an outer surface 226 and an inner surface 231, which face opposite directions. The outer surface 226 faces away from the central axis 295 and the inner surface 231 faces towards the central axis 295. The outer surface 226 has a convex contour and the inner surface 231 has a concave contour.

In some examples, the electrical contact pads 224 are formed on both the outer surface 226 and the inner surface 231 to maximize the number of electrical connections enabled by the electrical connector 200. Moreover, the electrical contact pads 224 of the electric contact-pad interface 223 are grouped into different annular pad patterns extending circumferentially along the width of the flexible substrate 222. Each one of the annular pad patterns includes an annular arrangement of electrical contact pads 224 spaced apart from each other in the circumferential direction along the width of the flexible substrate 222. The electrical contact pads 224 of a given annular pad pattern are circumferentially aligned (i.e., located the same distance from the end of the engagement end portion 239 in the axial direction or a plane perpendicular to the central axis 295 bisects all of the electrical contact pads 224 of the pattern).

In the illustrated example, the electrical contact pads 224 are grouped into a first pad pattern 224A and a second pad pattern 224B. The first pad pattern 224A is formed on the outer surface 226 of the flexible substrate 222. The second pad pattern 224B is formed on the inner surface 231 of the flexible substrate 222. The electrical contact pads 224 of the first pad pattern 224A and the second pad pattern 224B can be situated the same distance from the end of the engagement end portion 239, such as coexistent or flush with the end of the engagement end portion 239.

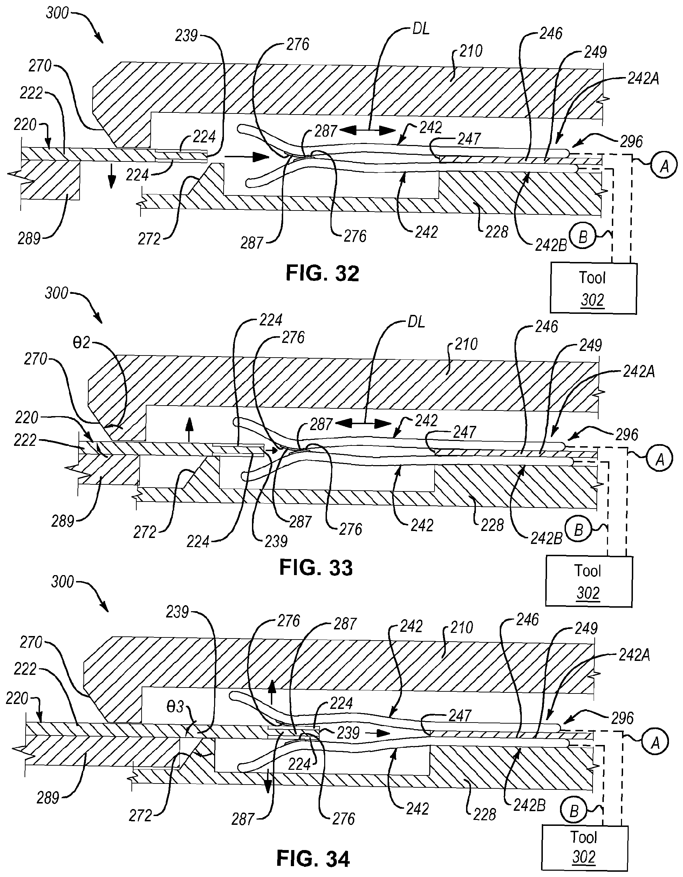

The electrical contact pads 224 of a given pad pattern are non-staggered or circumferentially aligned. Because each side of the flexible substrate 222 has only one pattern of pads, all the electrical contact pads 224 on each side of the flexible substrate 222 are non-staggered. Circumferential alignment between the electrical contact pads 224 of a given pad pattern can mean the electrical contact pads of a given pad pattern in the circumferential direction are aligned, which can mean the centers (i.e., the midpoints of the electrical contact pads in the longitudinal direction *DL* (see, e.g., Figure 32), perpendicular to the circumferential direction) of the electrical contact pads are in the same plane, where the plane is perpendicular to the central axis 295.

Referring to Figures 23-25, 36, and 37, more details of the electrical contact interface 240 of the plug 202 are shown. The annular FCB 246 of the plug 202 has an outer surface and an inner surface, which face opposite directions. The outer surface faces away from the central axis 295 and the inner surface faces towards the central axis 295. As with the annular FCB 220, both the outer surface and the inner surface of the annular FCB 246 are contoured or curved, such that the outer surface has a convex contour and the inner surface has a concave contour. The outer surface of the annular FCB 246 includes a first pattern of contact pads and corresponding traces. Similarly, the inner surface of the annular FCB 246 includes a second pattern of contact pads and corresponding traces. In some examples, the flexible electrical contacts 242 of the electrical contact interface 240 are attached to both corresponding ones of the contact pads on the outer surface of the annular FCB 246 and corresponding ones of the contact pads on the inner surface of the annular FCB 246 to maximize the number of electrical connections enabled by the electrical connector 200. Moreover, the flexible electrical contacts 242 are grouped into different annular contact patterns extending circumferentially along the width of the annular FCB 246.

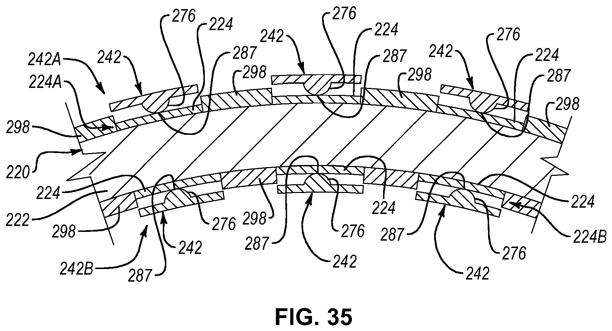

Each one of the annular contact patterns includes an annular arrangement of electrical contact points 287 (see, e.g., Figure 35) of the flexible electrical contacts 242, which are spaced apart from each other in a circumferential direction so that a gap is defined between the flexible electrical contacts 242 defining a given annular contact pattern. Accordingly, the electrical contact points 287 of a given annular pad pattern are circumferentially aligned (i.e., located the same distance from the end 247 of the annular FCB 246). The electrical contact points 287 are the points or portions of the flexible electrical contacts 242 configured to mechanically contact and establish an electrical connection with a corresponding one of the electrical contact pads 224 when the plug 202 and the receptacle 204 are mated.

In the illustrated example, the flexible electrical contacts 242 are grouped into a first contact pattern 242A and a second contact pattern 242B (see, e.g., Figure 35). The first contact pattern 242A is attached to the outer surface of the flexible substrate 249 of the annular FCB 246. In contrast, the second contact pattern 242B is attached to the inner surface of flexible substrate 249 of the annular FCB 246. As shown in Figures 32 34, the electrical contact points 287 of the first contact pattern 242A are longitudinally offset, in the longitudinal direction *DL,* relative to the electrical contact points 287 of the second contact pattern 242B, to help prevent scissoring of the flexible electrical contacts 242 that radially overlap with each other. In other words, the electrical contact points 287 of the first contact pattern 242A are situated further away from the end 247 of the annular FCB 246 than the electrical contact points 287 of the second contact pattern 242B. However, in alternative examples, the electrical contact points 287 of the first contact pattern 242A can be situated closer to the end 247 of the annular FCB 246 than the electrical contact points 287 of the second contact pattern 242B.

In some examples, such as is shown in Figures 32-34, the longitudinal offset between the electrical contact points 287 of the first contact pattern 242A and the second contact pattern 242B is facilitated by longitudinally offsetting the attachment points of the flexible electrical contacts 242 of the first contact pattern 242A relative to the attachment points of the flexible electrical contacts 242 of the second contact pattern 242B on the flexible substrate 249. In these examples, the flexible electrical contacts 242 of both the first contact pattern 242A and the second contact pattern 242B can be identically sized and shaped. However, in other examples (not shown), the flexible electrical contacts 242 of the first contact pattern 242A and the second contact pattern 242B are sized and shaped differently so that their attachment points on the flexible substrate 249 are not longitudinally offset, but their electrical contact points 287 are longitudinally offset.

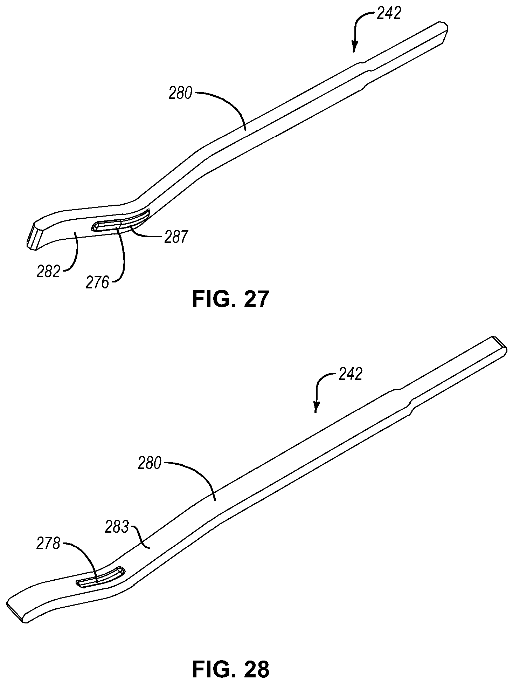

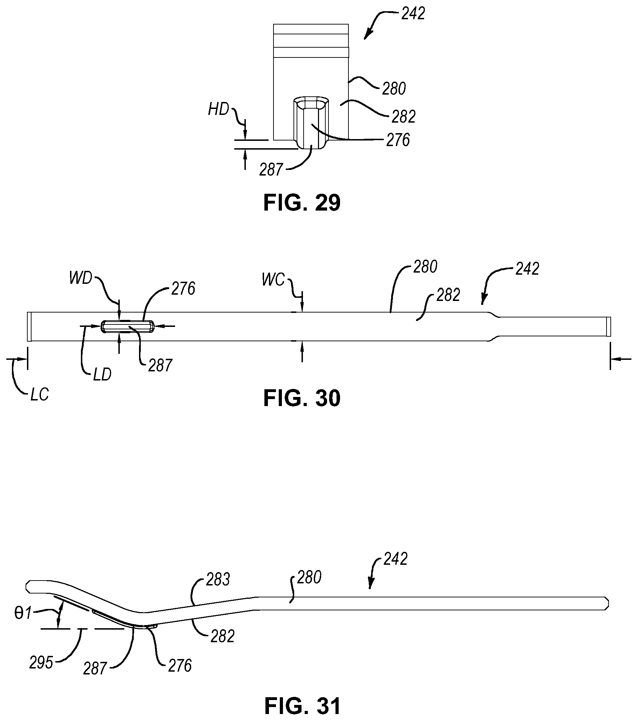

Referring to Figures 27-31, the electrical contact point 287 of each one of the flexible electrical contacts 242 is proximate a cantilevered end of the corresponding flexible electrical contact 242. More specifically, the electrical contact point 287 of the flexible electrical contact 242 is defined by a contact rib 276 of the flexible electrical contact 242. The flexible electrical contact 242 includes an elongated arm 280 that extends from a fixed end of the elongated arm 280 to a free end or cantilevered end of the elongated arm 280. A length *LC* of the elongated arm 280 is defined as the distance between the fixed end and the free end of the elongated arm 280. The elongated arm 280 has a first broad surface 283 (facing away from the central axis 295 for the flexible electrical contacts 242 of the first contact pattern 242A and facing toward the central axis 295 for the flexible electrical contacts 242 of the second contact pattern 242B), and a second broad surface 282 (facing toward the central axis 295 for the flexible electrical contacts 242 of the first contact pattern 242A and facing away from the central axis 295 for the flexible electrical contacts 242 of the second contact pattern 242B). Each one of the first broad surface 283 and the second broad surface 282 defines a maximum width *WC* of the electrical contact point 287. A thickness of the elongated arm 280 is defined as the distance between the first broad surface 283 and the second broad surface 282, and can be less than the maximum width *WC* of the elongated arm 280.

The contact rib 276 protrudes from the second broad surface 282 toward the central axis 295 or away from the central axis 295 depending on the contact pattern. A height *HD* of the contact rib 276 is defined as a distance that the contact rib 276 protrudes from the second broad surface 282. In some examples, the contact rib 276 is elongated along the length *LC* of the elongated arm 280. In other words, a length *LD* of the contact rib 276, which extends parallel to the length *LC* of the elongated arm 280, is greater than a width *WD* of the contact rib 276. Moreover, the length *LD* of the contact rib 276 is greater than the length *LC* of the elongated arm 280 and the width *WD* of the contact rib 276 is less than the width *WC* of the elongated arm 280. Accordingly, the contact rib 276 extends along only a small portion of the length *LC* of the elongated arm 280 and along only a portion of the width *WC* of the elongated arm 280. In some examples, the length *LD* of the contact rib 276 is less than 10%, less than 5%, or less than 3% of the length *LC* of the elongated arm 280, and the width *WD* of the contact rib 276 is less than 60%, less than 50%, less than 40%, or less than 30% of the width *WC* of the elongated arm 280.

In some examples, the flexible electrical contacts 242 are made using a metal stamping process. For example, each flexible electrical contact 242 can be formed by stamping without a subsequent bending of the flexible electrical contact 242. When stamping the flexible electrical contact 242 to form the contact rib 276 in second broad surface 282, a corresponding recess 278 is formed in the first broad surface 283.

The contact rib 276 is coupled to (e.g., formed in) a cantilevered end portion of the elongated arm 280. For each one of the flexible electrical contacts 242 of the first contact pattern 242A, an angled section of the cantilevered end portion is angled away from the central axis 295 and at an angle θ1 relative to the central axis 295. In contrast, for each one of the flexible electrical contacts 242 of the second contact pattern 242B, an angled section of the cantilevered end portion is angled toward the central axis 295 at the angle θ1 relative to the central axis 295. At least a portion of the contact rib 276 is coupled to the angled section of the cantilevered end portion of the elongated arm 280, such that at least a portion of the contact rib 276 is angled at the angle θ1 relative to the central axis 295.

Each one of the flexible electrical contacts 242 of the first contact pattern 242A is circumferentially aligned with a corresponding one of the flexible electrical contacts 242 of the second contact pattern 242B. In other words, along a radial plane parallel to and passing through the central axis 295, each one of the flexible electrical contacts 242 of the first contact pattern 242A overlaps with a corresponding one of the flexible electrical contacts 242 of the second contact pattern 242B. Accordingly, the flexible electrical contacts 242 of the first contact pattern 242A and the second contact pattern 242B can be divided into multiple pairs of overlapping ones of the flexible electrical contacts 242. Referring to Figures 32-34, which depicts a representative pair of overlapping ones of the flexible electrical contacts 242, the flexible electrical contacts 242 of each pair are pre-loaded or pre-biased toward each other, such that before the plug 202 is mated with the receptacle 204, the flexible electrical contacts 242 of each pair are in contact with each other at a location away from the end 247 of the annular FCB 246. In certain examples, before the plug 202 is mated with the receptacle 204, the contact ribs 276 of the flexible electrical contacts 242 of each pair are in contact with each other.

Referring to Figures 22, 26, and 32-34, the plug 202 further includes features for ensuring circularity of the annular FCB 220 and concentricity of the annular FCB 220 with the central axis 295 before the annular FCB 220 of the receptacle 204 is mated with the flexible electrical contacts 242 of the plug 202. According to one example, the plug 202 includes an outer chamfer 270 and an inner chamfer 272. The outer chamfer 270 is formed in the housing 210 of the plug 202 and the inner chamfer 272 is formed in the central engagement element 228 of the plug 202. Each one of the outer chamfer 270 and the inner chamfer 272 has an angled surface that faces toward the annular FCB 220 of the receptacle 204 as the receptacle 204 and the plug 202 are being mated. Moreover, the angled surface of the outer chamfer 270 is angled to face radially inwardly toward the central axis 295 and the inner chamfer 272 is angled to face radially outwardly away from the central axis 295. The angled surface of the outer chamfer 270 defines a second angle θ2 relative to the central axis 295 (see, e.g., Figure 33) and the angled surface of the inner chamfer 272 defines a third angle θ3 relative to the central axis 295 (see, e.g., Figure 34). In some examples, the second angle θ2 is the same as the third angle θ3. However, in other examples, the second angle θ2 is different than (e.g., less than) the third angle θ3. The outer chamfer 270 and the inner chamfer 272 have a generally annular or ring-like shape. The angled surfaces of the outer chamfer 270 and the inner chamfer 272 can be a continuous, annular-shaped surface. However, in other examples, such as shown, the angled surface of each one of the outer chamfer 270 and the inner chamfer 272 is made up of a series of spaced apart segments. In such examples, because the segments are arranged in an annular pattern, the chamfers are still considered annular chamfers for purposes of this disclosure.

The outer chamfer 270 and the inner chamfer 272 are radially offset by a distance substantially equal to or just greater than a thickness of the annular FCB 220 at the electric contact-pad interface 223. Additionally, in certain examples, the outer chamfer 270 and the inner chamfer 272 are longitudinally offset, such that the outer chamfer 270 is closer to the receptacle 204 than the inner chamfer 272 as the receptacle 204 is being mated with the plug 202.

Referring to Figures 20 and 23, with the central axis of the plug 202 and the central axis of the receptacle 204 being substantially coaxial, the plug 202 can be inserted into the receptacle 204. As shown in Figure 32, as the plug 202 is inserted into the receptacle 204 in the longitudinal direction *DL,* any part of the engagement end portion 239 of the annular FCB 220 of the receptacle 204, which renders the engagement end portion 239 radially outwardly lopsided (non-round and larger than an intended circumference), slidably engages the outer chamfer 270 of the housing 210. Slidable engagement with the angled surface of the outer chamfer 270 urges the part radially inwardly, as shown by a directional arrow, and within an intended circumference. Referring again to Figure 32, as the plug 202 is further inserted into the receptacle 204, any part of the engagement end portion 239 of the annular FCB 220 of the receptacle 204, which renders the engagement end portion 239 radially inwardly lopsided (non-round and smaller than an intended circumference), slidably engages the inner chamfer 272 of the central engagement element 228. Slidable engagement with the angled surface of the inner chamfer 272 urges the part radially outwardly, as shown by a directional arrow, to meet the intended circumference. In this manner, the outer chamfer 270 and the inner chamfer 272 ensure that the engagement end portion 239 of the annular FCB 220 is round and concentric with the central axis 295 as the engagement end portion 239 approaches the flexible electrical contacts 242 (see, e.g., Figure 33). The engagement end portion 239 of the annular FCB 220, being round before engaging the flexible electrical contacts 242, promotes a strong and reliable connection between the flexible electrical contacts 242 and the electrical contact pads 224 (as described in more detail below), as well as minimizing possible damage to the annular FCB 220 by the electrical contact pads 224. Additionally, in some examples, the outer chamfer 270 and the inner chamfer 272 apply opposing retention forces to (e.g., clamp) the annular FCB 220 when the plug 202 and the receptacle 204 are fully engaged to help retain the annular FCB 220 in place during use.

Further insertion of the plug 202 into the receptacle 204 ultimately causes the engagement end portion 239 of the annular FCB 220 to contact the flexible electrical contacts 242. Contact with the flexible electrical contacts 242 urges each pair of flexible electrical contacts 242 to flex away from each other so that the contact ribs 276 separate from each other on account of the engagement end portion 239 passing therebetween. Referring to Figure 35, the contact ribs 276 of the flexible electrical contacts 242 engage corresponding ones of the electrical contact pads 224 to establish an electrical connection with the corresponding ones of the electrical contact pads 224. Engagement includes radial flexing (i.e., flexing in a radial direction) of the flexible electrical contacts 242 and sliding of the electrical contact points 287, defined by the contact ribs 276, along the at least a portion of the corresponding ones of the electrical contact pads 224. The cantilevered ends of the flexible electrical contacts 242, including the contact ribs 276, being angled, beveled, or sloped, helps to facilitate initial engagement with the substrate 222 and initial radial flexing of the flexible electrical contacts 242.

In the illustrated examples, the flexible electrical contacts 242 of the first contact pattern 242A flex radially outwardly away from the central axis 295 so that the electrical contact point 287 of each one of the flexible electrical contacts 242 of the first contact pattern 242A makes electrical contact with a corresponding one of the electrical contact pads 224 of the first pad pattern 224A. In contrast, the flexible electrical contacts 242 of the second contact pattern 242B flex radially inwardly toward the central axis 295 so that the electrical contact point 287 of each one of the flexible electrical contacts 242 of the second contact pattern 242B makes electrical contact with a corresponding one of the electrical contact pads 224 of the second pad pattern 124B.

In some examples, the force applied to each other by the electrical contact points 287 of a given pair of opposing flexible electrical contacts 242 is between, and inclusive, of 0 and 40 grams. In contrast, in some examples, when the plug 202 is mated with the receptacle 204, the electrical contact point 287 of each one of the flexible electrical contacts 242 applies a force to a corresponding one of the electrical contact pads 124 that is between, and inclusive of, 15 and 60 grams.

In some instances, the flexible electrical contacts 242, being flexible and cantilevered, may be prone to lateral movement (e.g., in circumferential direction) and scissoring relative to a radially adjacent flexible electrical contact 242. In certain examples, as shown in Figure 35, the annular FCB 220 (as well as the annular FCB 246), includes a solder mask 298 on each one of the outer surface 226 and the inner surface 231, and between the electrical contact pads 224. The solder mask 298 facilitates the formation of the electrical contact pads 224 on the flexible substrate 222, and remains on the flexible substrate 222. In certain examples, the electrical contact pads 224 are recessed relative to the solder mask 298. The contact rib 276, protruding from the elongated arm 280, helps to maintain a proper electrical connection between the flexible electrical contact 242 and the electrical contact pad 224, even when the elongated arm 280 may be experiencing a scissoring effect. Without the contact rib 276, the flexible electrical contact 242 would have to be properly aligned with the electrical contact pad 224 to ensure electrical contact between the flexible electrical contact 242 and the electrical contact pad 224 because any scissoring (lateral movement) of the flexible electrical contact 242 would result in the solder mask 298 interfering with the ability of the flexible electrical contact 242 to flex into contact with the electrical contact pad 224.

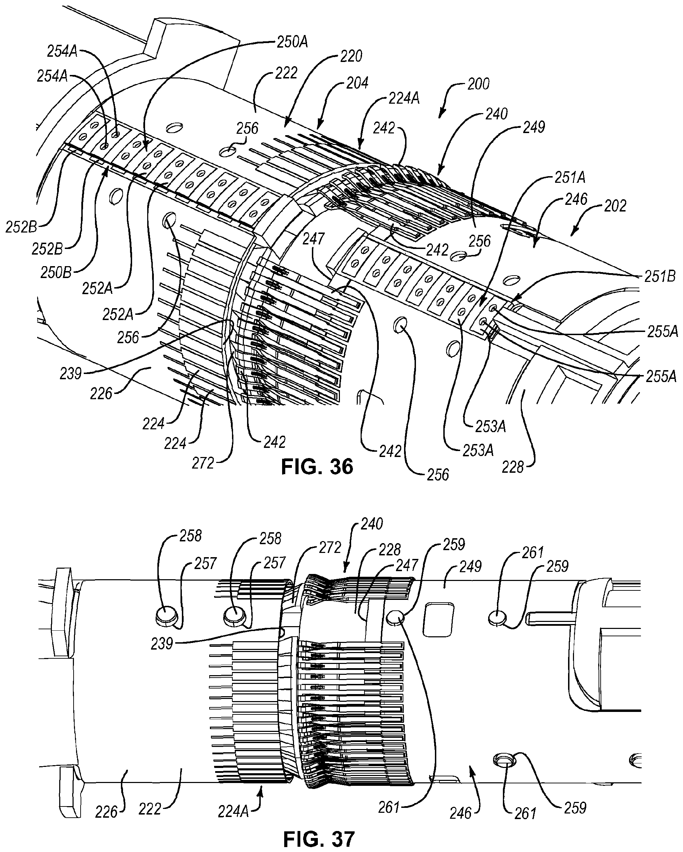

Referring to Figure 36, in some examples, the overlapping portions of the flexible substrate 222 and the flexible substrate 249 are connected together via corresponding solder bridges. For example, the flexible substrate 222 of the annular FCB 220 includes a first overlapping portion 250A and a second overlapping portion 250B at corresponding ends of the flexible substrate 222. As used herein, in some examples, an overlapping portion can be defined as a overlapping side portion because side portions of the flexible substrate are overlapping. The first overlapping portion 250A and the second overlapping portion 250B form an overlapping joint. The joint is held together by solder bridges each defined by a corresponding one of first solder pads 252A, formed in the first overlapping portion 250A, a corresponding one of second solder pads 252B, formed in the second overlapping portion 250B, and solder (not shown) between the first solder pads 252A and the second solder pads 252B. The first solder pads 252A and the second solder pads 252B are made of a metallic material, and the surrounding portions of the flexible substrate 222. According to one example, each solder bridge is formed by applying a solder material onto the second solder pads 252B before the overlapping portions are overlapped. The first overlapping portion 250A and the second overlapping portion 250B are then overlapped such that a corresponding one of the first solder pads 252A overlaps with a corresponding one of the second solder pads 252B, and the solder material is interposed between the first solder pads 252A and the second solder pads 252B. The solder material is heated to reflow the solder and fuse the solder material to the first solder pads 252A and the second solder pads 252B, thus creating a soldered overlapping joint between the first overlapping portion 250A and the second overlapping portion 250B.

In some examples, each one of the first solder pads 252A includes one or more vias 254A or holes, which extend entirely through the first solder pads 252A. The vias 254A, being open to the solder material between the first solder pads 252A and the second solder pads 252B, enables the solder material, when reflowed, to flow into and through vias 254A. Accordingly, when reflowed, a portion of the solder material is located within the vias 254A and, optionally, on top of the first solder pads 252A. When hardened, the solder material in the vias 254A and on top of the first solder pads 252A promotes a stronger soldered overlapping joint between the first solder pads 252A and the second solder pads 252B.

Similar to the flexible substrate 222 of the annular FCB 120, the flexible substrate 249 of the annular FCB 246 includes a first overlapping portion 251A and a second overlapping portion 251B at corresponding ends of the flexible substrate 249 that form an overlapping joint. The joint is held together by solder bridges each defined by a corresponding one of first solder pads 253A, formed in the first overlapping portion 251A, a corresponding one of second solder pads (not shown), formed in the second overlapping portion 251B, and solder (not shown) between the first solder pads 253A and the second solder pads. In some examples, to help form the overlapping soldered joint, each one of the first solder pads 253A includes one or more vias 255A or holes, which extend entirely through the first solder pads 253A.

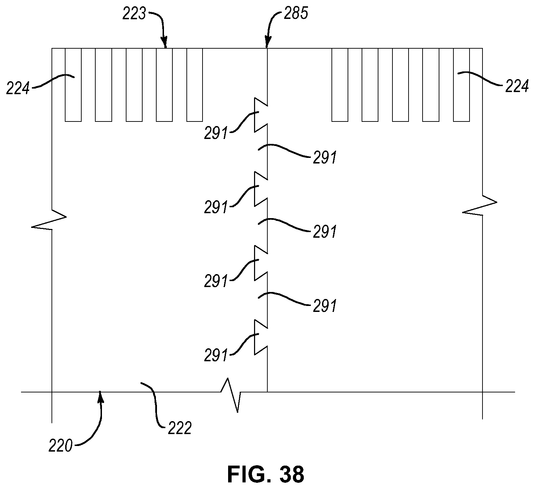

According to alternative examples, as shown in Figure 38, opposing sides of the flexible substrates (e.g., the flexible substrate 222) can be joined together via an interlocking joint 285 (i.e., interdigitation) to form the flexible substrates into a circular shape or a hoop. In one example, the interlocking joint 285 includes a plurality of interlocking features 291, such as tabs, ears, tongues, etc. The interlocking features 291 of one side of the flexible substrate engage with the interlocking features 291 of the opposite side of the flexible substrate to form the interlocking joint 285. More specifically, in one example, the interlocking features 291 (e.g., tongues) of one end of the flexible substrate are inserted into corresponding grooves of the opposite end of the flexible substrate, and vice versa. A bonding agent or adhesive can be applied onto and/or between the interlocking features 291 along the interlocking joint 285 to strengthen the interlocking joint 285.

As the opposing sides of the flexible substrate are brought together, and the flexible substrate is shaped into a circle or hoop, temporarily holding the opposing sides together while the permanent joint between the opposing sides is formed can be difficult. Accordingly, in one example, the flexible substrate (e.g., the flexible substrate 222 and/or the flexible substrate 249) includes one or more apertures 256 adjacent to each one of the opposing sides of the flexible substrate. More specifically, in certain examples, the flexible substrate 222 includes a pair of apertures 256 adjacent one side of the flexible substrate 222 and a pair of apertures 256 adjacent the opposite side of the flexible substrate 222. Likewise, in some examples, the flexible substrate 249 includes a pair of apertures 256 adjacent one side of the flexible substrate 249 and a pair of apertures 256 adjacent the opposite side of the flexible substrate 249. Although not shown, a fixation tool (e.g., e.g., a clamp, buckle, latch, etc.) can span the joint between opposing sides of a flexible substrate and engage the apertures 256 of the flexible substrate to prevent the opposing sides from separating while being joined together. According to some alternative examples, the apertures 256 can be replaced or supplemented by different types of engagement elements that promote attachment of a fixation tool to the flexible substrate. It is also recognized that in some examples, the flexible electrical contacts 242 are electrically connected (e.g., soldered) to the annular FCB 246, when flat and before the annular FCB 246 is shaped into the annular shape.

As shown in Figure 37, in certain examples, the annular FCB 220 includes registration features, such as registration apertures 257. The housing 212 or the frame 289 can also include corresponding registration features, such as pins 258, protrusions, or tabs, that engage the registration features (e.g., the registration apertures 257) of the annular FCB 220. Engagement between the registration features of the annular FCB 220 and the housing 212 or the frame 289 helps to properly locate and orientate the annular FCB 220 relative to the housing 212 or the frame 289. Like the annular FCB 220, the annular FCB 246 includes registration features, such as registration apertures 259, which can engage registration features, such as pins 261, of the housing 210 or the central engagement element 228 to help properly locate and orientate the annular FCB 246 relative to the housing 210 or the central engagement element 228.

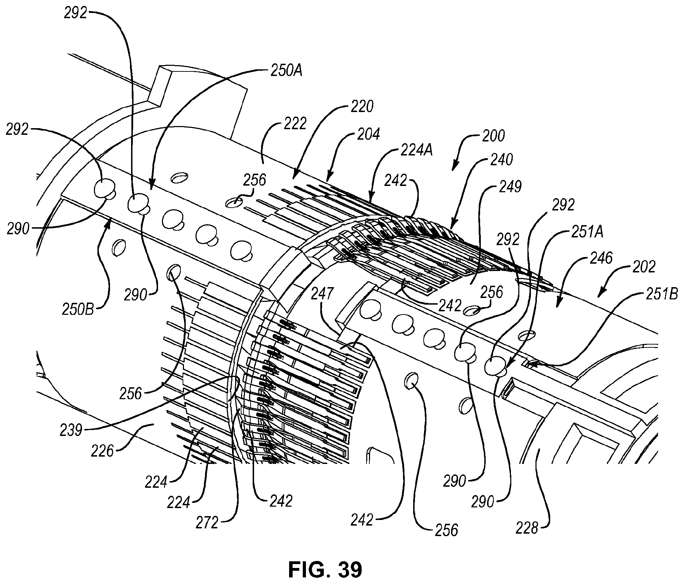

According to alternative examples, as shown in Figure 39, the first overlapping portion 250A and the second overlapping portion 250B of the receptacle 204 are coupled together, to form the overlapping joint, via a plurality of posts 292 (e.g., pegs) formed in the housing 112 or other portion of the receptacle 104. Each overlapping portion includes openings 290 (e.g., apertures) that are alignable with each other when the annular FCB 220 has a predetermined circumference. Moreover, the posts 292 are located on the housing 112 so that when the openings 290 are aligned, a corresponding one of the posts 292 can pass through the aligned openings. In this manner, a predetermined circumference of the annular FCB 220 can be achieved and maintained during assembly and use of the receptacle 204. For example, according to some embodiments, during assembly of the receptacle 204, the annular FCB 220 is positioned so that the posts 292 pass through the corresponding openings 290 of the second overlapping portion 250B, thus securing the second overlapping portion 250B relative to the housing 112. Then, the annular FCB 220 is reshaped into a circular shape so that the posts 292 also pass through the corresponding openings 290 of the first overlapping portion 250A, thus forming the overlapping joint and securing the first overlapping portion 250A relative to the housing 112. The position of the openings 290 on the annular FCB 220 are precisely controlled so that when the posts 292 pass through the openings 290 of the first overlapping portion 250A and the second overlapping portion 250B, the circumference of the annular FCB 220 is a predetermined desired circumference. To retain the overlapping portions on the posts 292, a heat staking process can be applied to the posts 292 to melt down a portion of the posts 292, which forms a retention portion of the posts 292. The retention portion has a size that is greater than the openings so that the annular FCB 220 does not slide off of the posts 292 and the annular FCB 220 is retained on the housing 112 with the predetermined desired circumference. Techniques, other than or in addition to heat staking, can be used to retain the overlapping portions on the posts 292, such as adhesion techniques, bonding techniques, or the like.

Also shown in Figure 39, the first overlapping portion 251A and the second overlapping portion 251B of the plug 202 are coupled together, to form the overlapping joint, via engagement between openings 290 in the annular FCB 246 and a plurality of posts 292 formed in the housing 110 or other portion of the plug 102, in the same manner as described above for the receptacle 204. Like the receptacle 204, the position of the openings 290 on the annular FCB 246 are precisely controlled so that when the posts 292 pass through the openings 290 of the first overlapping portion 251A and the second overlapping portion 251B, the circumference of the annular FCB 246 is a predetermined desired circumference. The annular FCB 246 can be retained on the housing 110 via heat staking processing of the posts 292 as described above.

Referring to Figures 32-34, according to some examples, a system 300 includes the plug 202 and a tool 302. The tool 302 is electrically coupled to the flexible electrical contacts 242, such as via the annular FCB 246. For example, as shown, the tool 302 is separately electrically coupled to each one of the pair of flexible electrical contacts 242 at fixed ends 296 of the contacts. The tool 302 transmits data signals to and/or receives data signals from and a corresponding tool control system electrically coupled with the tool 302 when the plug 202 is properly mated with the receptacle 204, which separates (e.g., electrically isolates) the flexible electrical contacts 242 of the pair. The intensity of the data signals is small and can be difficult to detect. However, before the plug 202 is mated with the tool 302, the flexible electrical contacts 242 of the pair are electrically connected such that a circuit, including the flexible electrical contacts 242 of the pair, is shorted. In certain examples, the tool 302 is configured to sense a short in the circuit containing the pair of flexible electrical contacts 242. In other words, the tool 302 is configured to detect when the pair of flexible electrical contacts 242 are electrically connected (i.e., unseparated). In some examples, the tool 302 includes electronic circuitry, one or more electronic controllers, and/or one or more computer modules that are programmed to detect when the pair of flexible electrical contacts 242 are electrically connected.

Prior to mating the plug 202 with the receptacle 204, each pair of flexible electrical contacts 242 are electrically connected or shorted. When the plug 202 and the receptacle 204 are properly mated, each pair of flexible electrical contacts 242 are separated and the short circuit is removed. Therefore, the tool 302 is enabled to determine whether the plug 202 and the receptacle 204 are properly mated by sensing the existence or absence of a short circuit between at least one pair of flexible electrical contacts 242. Because sensing the existence of a short circuit is easier than detecting the presence of a data signal through a flexible electrical contact, determining a proper connection between the plug 202 and the receptacle 204 via detection of a short circuit is more accurate and reliable than via detection of a data signal. In this manner, the system 300 can provide a fail-safe method of ensuring the proper electrical mating between the plug 202 and the receptacle 204.

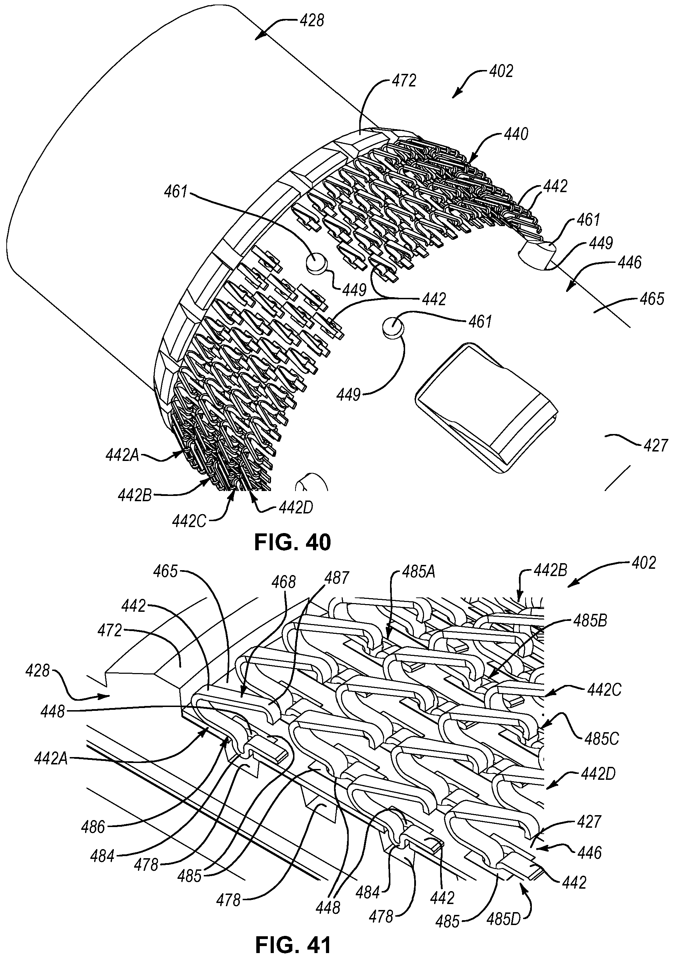

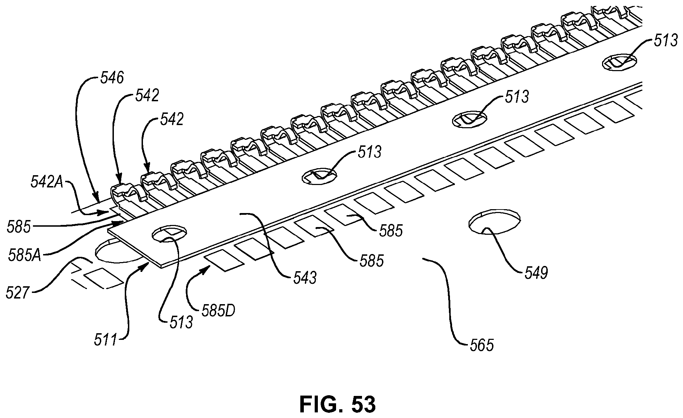

Referring Figures 40-43, an alternative example of a plug 402 is shown. The plug 402 includes some features analogous to features of the plug 102. In fact, unless otherwise noted, like numbers (400-series for the plug 402 and 100-series for the plug 102) refer to analogous features. Although not shown, the plug 402 can include a housing and circuit boards extending from the housing, as described above in relation to the plug 102. The plug 402 further includes an electrical contact interface 440 that includes flexible electrical contacts 442 arranged in a set of annular patterns corresponding with a set of annular patterns of the electrical contact pads 124 forming the electrical contact-pad interface 123 of the annular FCB 120. Accordingly, the annular patterns of the flexible electrical contacts 442 are staggered relative to adjacent ones of the annular patterns in the same manner as the flexible electrical contacts 142 of the plug 102. Referring to Figures 40 and 41, the flexible electrical contacts 442 are fixed to and extend from an outer surface 427 of an annular FCB 446 of the plug 402. The flexible electrical contacts 442 are electrically coupled with one or more electrical traces of the annular FCB 446. The FCB 446 can have the same features as the FCB 146. For example, the FCB 446 includes a flexible substrate 465 that has an outer surface 427 and an inner surface 409, which is opposite the outer surface 427 and separated from the outer surface 427 by a thickness of the flexible substrate 465. The flexible substrate can also have registration apertures 549 (see, e.g., Figure 53).

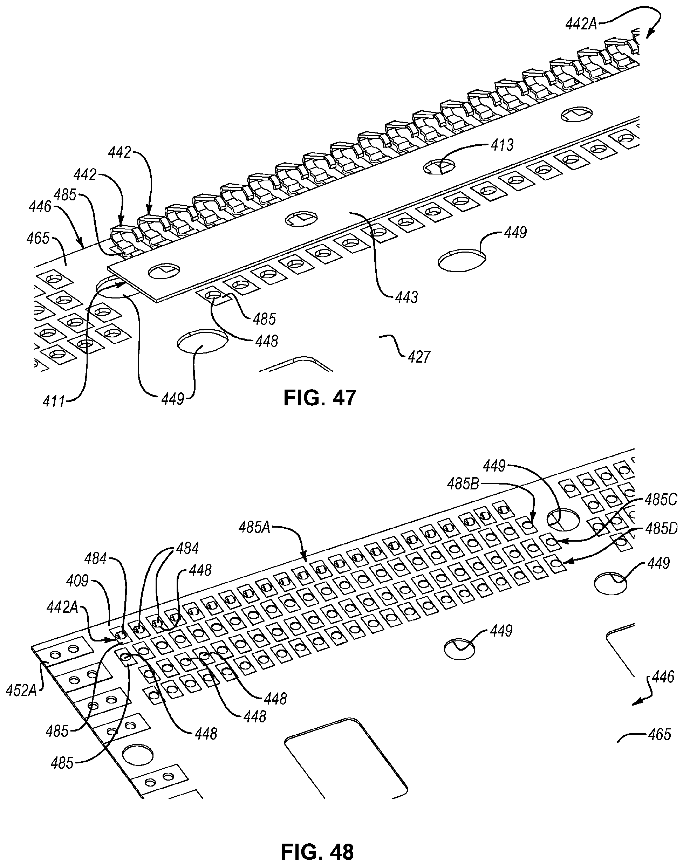

The FCB 446 further includes mounting pads 485 formed in both the outer surface 427 and the inner surface 409 of the flexible substrate 465. Each one of the mounting pads 485 is made of an electrically conductive material, such as copper, and extends from the outer surface 427 to the inner surface 409 through the thickness of the flexible substrate 465. Accordingly, in some examples, the mounting pads 485 have a thickness equal to the thickness of the flexible substrate 465. Each one of the mounting pads 485 additionally includes a contact aperture 448 that extends entirely through the thickness of the mounting pad 485 (see, e.g., Figures 47 and 48).

The mounting pads 485 are grouped into different annular mounting-pad patterns extending circumferentially along the width of the flexible substrate 465. Each one of the annular mounting-pad patterns includes an annular arrangement of mounting pads 485 spaced apart from each other in the circumferential direction along the width of the flexible substrate 465. The mounting pads 485 of a given annular mounting-pad pattern are circumferentially aligned. However, in certain examples, the mounting pads 485 of a mounting-pad pattern are longitudinally offset from the mounting pads 485 of any other mounting-pad pattern. In other words, no mounting pads 485 of one mounting-pad pattern overlap with, in the circumferential direction, any of the mounting pads 485 of any other mounting-pad pattern. Additionally, the mounting pads 485 of a given annular pad pattern have the same size and shape in some examples.

In the illustrated example, the mounting pads 485 are grouped into a first mounting-pad pattern 485A, a second mounting-pad pattern 485B, a third mounting-pad pattern 485C, and a fourth mounting-pad pattern 485D. All of the mounting-pad patterns are formed in the flexible substrate 465 such that the mounting-pad patterns are accessible from the outer surface 427 and the inner surface 409 of the flexible substrate 465. The mounting pads 485 of the first mounting-pad pattern 485A are situated closer to the leading end of the flexible substrate 465 than the mounting pads 485 second mounting-pad pattern 485B. Likewise, the mounting pads 485 of the second mounting-pad pattern 485B are situated closer to the leading end of the flexible substrate 465 than the mounting pads 485 of the third mounting-pad pattern 485C. Finally, the mounting pads 485 of the third mounting-pad pattern 485C are situated closer to the leading end of the flexible substrate 465 than the mounting pads 485 of the fourth mounting-pad pattern 485D.

Adjacent mounting-pad patterns are staggered. More specifically, the mounting pads 485 of one mounting-pad pattern are staggered relative to the mounting pads 485 of an adjacent mounting-pad pattern. As defined herein, a mounting-pad pattern is staggered relative to an adjacent mounting-pad pattern when each one of the mounting pads 485 of the mounting-pad pattern is not aligned with, in the longitudinal direction, any one of the mounting pads 485 of the adjacent mounting-pad pattern. Alignment or non-alignment of two mounting pads is defined in the same manner as the alignment or non-alignment of two contact pads, as defined above.

Although four mounting-pad patterns are shown, it is recognized that in some examples, the plug 402 can have fewer or more than four mounting-pad patterns. In examples having three or more mounting-pad patterns, such as shown, although adjacent ones of the mounting-pad patterns are staggered relative to each other, non-adjacent ones of the mounting-pad patterns may not be staggered relative to each other. For example, the mounting pads 485 of the first mounting-pad pattern 485A can be longitudinally aligned with the mounting pads 485 of the third mounting-pad pattern 485C and not longitudinally aligned with the mounting pads 485 of the second mounting-pad pattern 485B between the first and third mounting-pad patterns. In this example, the first and second mounting-pad patterns are staggered relative to each other and the second and third mounting-pad patterns are staggered relative to each other. Accordingly, the plug 402 is considered to have staggered mounting-pad patterns, even if some of the mounting-pad patterns are not staggered relative to each other, as long as directly adjacent ones of the mounting-pad patterns are staggered. In certain examples, each one of the mounting pads 485 is electrically coupled with at least one electrical trace of the FCB 446.

Although staggering the mounting pads 485, the flexible electrical contacts 442, and electrical contact pads 424 of the FCB 420 (described below) in the above-mentioned manner can provide various benefits, such as an increase in the aerial density of the contacts and pads and a decrease in the wear on the contacts over multiple uses, in some examples, the mounting pads 485, the flexible electrical contacts 442, and electrical contact pads 424 are not staggered. In other words, in some examples, adjacent mounting-pad patterns and annular contact patterns are non-staggered. More specifically, referring to the mounting pads 485, the mounting pads 485 of one mounting-pad pattern can be longitudinally aligned relative to corresponding ones of the mounting pads 485 of an adjacent mounting-pad pattern. As defined herein, a mounting-pad pattern is non-staggered relative to an adjacent mounting-pad pattern when each one of the mounting pads 485 of the mounting-pad pattern is aligned with, in the longitudinal direction, any one of the mounting pads 485 of the adjacent mounting-pad pattern.

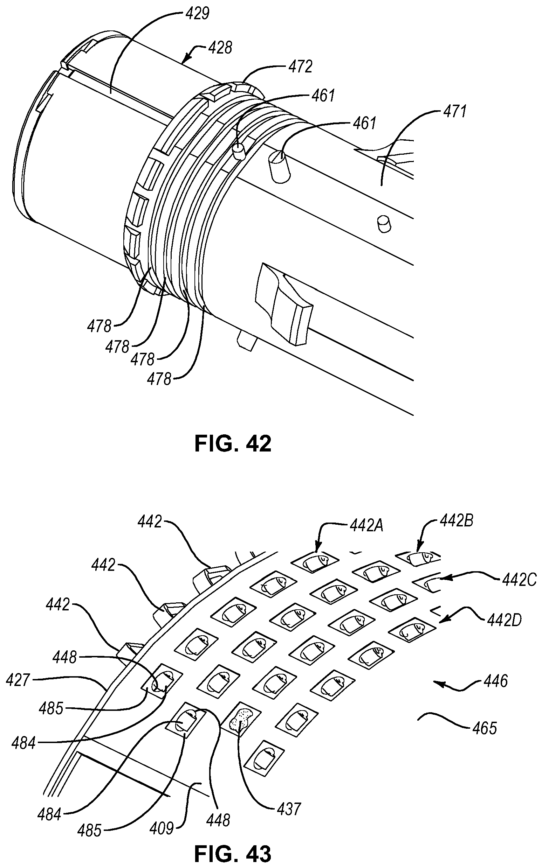

Referring to Figures 40, 41, and 43, more details of the electrical contact interface 440 of the plug 402 are shown. Both the outer surface 427 and the inner surface 409 of the annular FCB 446 are contoured or curved, such that the outer surface 427 has a convex contour and the inner surface 409 has a concave contour. The flexible electrical contacts 442 of the electrical contact interface 440 are attached to the outer surface 427. More specifically, each one of the flexible electrical contacts 442 is soldered to a corresponding one of the mounting pads 485. The soldering of the flexible electrical contacts 442 mechanically and electrically couples the flexible electrical contacts 442 to the mounting pads 485 and thus to the FCB 446. Soldering of each one of the flexible electrical contacts 442 is facilitated by enabling a jog 484 (e.g., peg, pin, protrusion, etc.) of a fixed portion 486 of the flexible electrical contact to extend through the contact aperture 448 of a corresponding one of the mounting pads 485 when the fixed portion 486 is on (e.g., in contact with) an outer surface of the corresponding one of the mounting pads 485. As shown in Figures 43, 44, and 45, the jog 484, or at least a portion of the jog 484, is directly soldered to the mounting pad 485 via solder 437. Electrical connectivity is established by both the direct contact between the fixed portion 486 and the outer surface of the mounting pad 485 and direct contact between the solder 437 and the inner surface of the mounting pad 485. In some examples, the jog 484 is soldered directly to the mounting pad 485 at an inner surface of the mounting pad 485. The inner surface of the mounting pad 485 is the surface of the mounting pad 485 that is flush with the inner surface 409 or that faces inwardly toward the central axis of the plug 402. Accordingly, the outer surface of the mounting pad 485 is the surface of the mounting pad 485 that is flush with the outer surface 427 or that faces outwardly away from the central axis of the plug 402.

Referring to Figures 47 and 48, in some examples, the flexible electrical contacts 442 are soldered to the mounting pads 485 before the FCB 446 is shaped into a cylinder and attached to the central engagement element 428. More specifically, the flexible electrical contacts 442 can be soldered to the mounting pads 485 when the FCB 446 is flat as shown in Figures 47 and 48. According to certain examples, a contact assembly 411 can be used to enable efficient soldering of multiple flexible electrical contacts 442 (e.g., an entire circumferential pattern of flexible electrical contacts 442 at the same time). The contact assembly 411 includes a spine 443 or fixture to which multiple flexible electrical contacts 442 are attached. In some examples, the spine 443 and flexible electrical contacts 442 are co-stamped from a single sheet of material. With the flexible electrical contacts 442 attached to the spine 443, the flexible electrical contacts 442 can be shaped from a flat shape into a final 3-dimentionsal shape. The spine 443 can have fixture apertures 413 that help facilitate handling of the contact assembly 411 during shaping of the flexible electrical contacts 442 and placement of the contact assembly 411 relative to the FCB 446 so that the jogs 484 of the flexible electrical contacts 442 are received in respective contact apertures 448 of the mounting pads 485. Solder 437 can then be applied about the jogs 484 and reflowed to solder the jogs 484 to the mounting pads 485. Soldering of jogs 484 can be performed one-by-one or concurrently, such as via an automated process. After the jogs 484 are soldered, the spine 443 can be manipulated (e.g., moved back and forth) relative to the flexible electrical contacts 442 to break the spine 443 away from the flexible electrical contacts 442, thus leaving the flexible electrical contacts 442 soldered in place on the FCB 446.

The flexible electrical contacts 442 are grouped into different annular contact patterns extending circumferentially along the width of the annular FCB 446. Each one of the annular contact patterns includes an annular arrangement of the flexible electrical contacts 142, which are spaced apart from each other in the circumferential direction so that a gap is defined between the flexible electrical contacts 442 defining a given annular contact pattern. The electrical contact points 487 of a given annular pad pattern are circumferentially aligned. Additionally, the flexible electrical contacts 442 of a contact pattern are longitudinally offset from the flexible electrical contacts 442 of any other contact pattern. In other words, no electrical contact points 487 of one contact pattern overlap with, in the circumferential direction, any of the electrical contact points 487 of any other contact pattern.

In the illustrated example, the flexible electrical contacts 442 are grouped into a first contact pattern 442A, a second contact pattern 442B, a third contact pattern 442C, and a fourth contact pattern 442D, which correspond with the location and position of the first mounting-pad pattern 485A, the second mounting-pad pattern 485B, the third mounting-pad pattern 485C, and the fourth mounting-pad pattern 485D, respectively. The flexible electrical contacts 442 of the first contact pattern 442A are situated closer to the end of the annular FCB 446 than the flexible electrical contacts 442 of the second contact pattern 442B. Likewise, the flexible electrical contacts 442 of the second contact pattern 442B are situated closer to the end of the annular FCB 446 than the flexible electrical contacts 442 of the third contact pattern 142C. Similarly, the flexible electrical contacts 442 of the third contact pattern 442C are situated closer to the end of the annular FCB 446 than the flexible electrical contacts 442 of the fourth contact pattern 142D.

Like the mounting-pad patterns, the contact patterns of the flexible electrical contacts 442 of the annular FCB 146 are staggered according to the definition above. More specifically, the flexible electrical contacts 442 of one contact pattern are staggered relative to the flexible electrical contacts 442 of an adjacent contact pattern. However, as mentioned above, in some examples, the flexible electrical contacts 442 can be non-staggered.

Although four contact patterns are shown, it is recognized that in some examples, the plug 402 can have fewer or more than four contact patterns. In examples having three or more contact patterns, such as shown, although adjacent ones of the contact patterns are staggered relative to each other, non-adjacent ones of the contact patterns may not be staggered relative to each other as defined above.

Referring generally to Figure 41, the electrical contact points 487 are proximate a cantilevered end of a movable portion 468 of the flexible electrical contacts 442. The movable portion 468 is connected to the fixed portion 486 via an elbow 469, which is resiliently deformable to enable the movable portion 468 to move (e.g., pivot) relative to the fixed portion 486. The flexible electrical contacts 442 are attached to the FCB 446 so that the elbow 469 and the movable portion 468 of the flexible electrical contacts 442 of all the contact patterns are on (e.g., extend from) the outer surface 427 of the flexible substrate 465 of the FCB 446, and at least a portion of the jog 484 of the flexible electrical contacts 442 of all the contact patterns are on (e.g., extend from) the inner surface 409 of the flexible substrate 465 of the FCB 446.

As shown in Figures 40, 41, 44, and 45, the FCB 446 is attached to the central engagement element 428 so that the inner surface 409 of the flexible substrate 465 is substantially flush with the outer surface 471 (see Figure 42) of the central engagement element 428. To enable flush attachment of the flexible substrate 465 on the central engagement element 428, the central engagement element 428 includes annular channels 478 or recesses. The annular channels 478 extend continuously along a circumference of the central engagement element 428 and are longitudinally (e.g., axially) spaced apart from each other a distance corresponding to the distance between the mounting-pad patterns. Accordingly, when the FCB 446 is attached to the central engagement element 428, the jogs 484 of the flexible electrical contacts 442 and the solder 437 associated with the flexible electrical contacts 442 of each one of the contact patterns is received within a corresponding one of the annular channels 478 (see, e.g., Figures 41, 44, and 45).

As mentioned above, the central engagement element 428 supports the FCB 446 flush against an outer surface of central engagement element 428. This helps the FCB 446 to maintain its shape and prevent hoop stresses from pulling apart the annular FCB 446. Similarly, although not shown, the receptacle (e.g., receptacle 104) can have a cylindrical internal backstop inside the housing of the receptacle. The cylindrical internal backstop provides a radially inwardly facing surface against which the annular FCB 420 is retained. In other words, a radially outwardly facing surface of the annular FCB 420 contacts and is flush against the radially inwardly facing surface of the cylindrical internal backstop, which helps to maintain the shape of the annular FCB 420 and prevent hoop stresses from pulling apart the annular FCB 420.

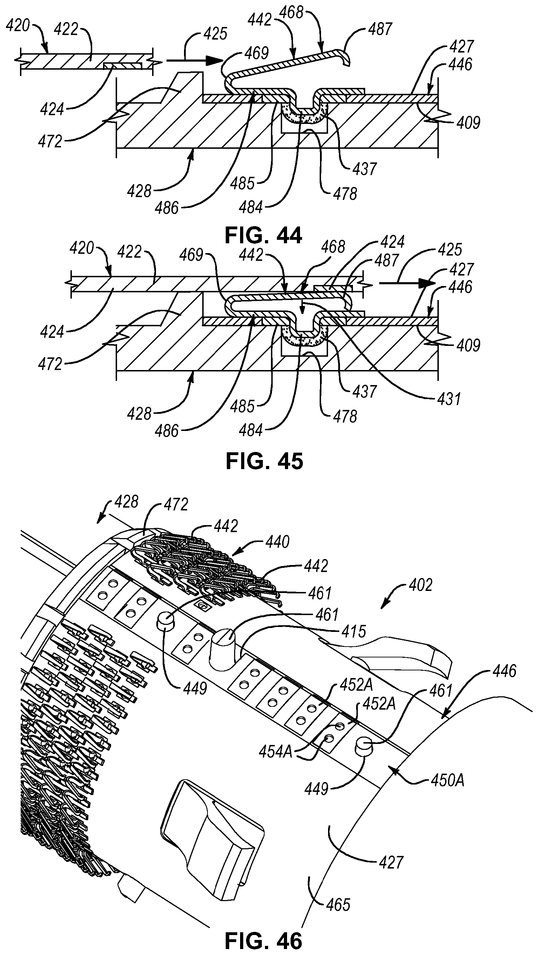

As shown in Figure 46, the central engagement element 428 includes pins 461 that are longitudinally aligned and spaced apart. The pins 461 are sized and shaped to engage a corresponding one of multiple registration apertures 449 or slots 415 formed in edge portions of the FCB 446. The edge portions are overlapped to form an overlapping portion 450A of the FCB 446 when attached to the central engagement element 428. A first one of the edge portions includes registration apertures that engage corresponding ones of the pins 461 and a registration slot that engages another one of the pins 461 to temporarily secure the first one of the edge portions to the central engagement element 428. Then, the FCB 446 is wrapped around the central engagement element 428 until the second one of the edge portions overlaps the first one of the edge portions, registration apertures 449 of the second one of the ledge portions engages corresponding ones of the pins 461, and the registration slot 415 engages the other one of the pins 461. Although the registration slot 415 is an open-ended slot in the illustrated example, in some examples, the registration slot 415 can be a closed-slot, such as a circular aperture. When the first and second edge portions are overlapped to form the overlapping portion 450A, which is an overlapping joint. The joint is held together by solder bridges each defined by overlapping solder pads 452A, formed in the overlapping edge portions of the FCB 446, and solder (not shown) between the overlapping solder pads 452A. In some examples, to help form the overlapping soldered j oint, each one of the solder pads 452A includes one or more vias 454A or holes, which extend entirely through the solder pads 452A. Although the overlapping joint is formed or secured using solder in the illustrated example, in other examples, the overlapping joint can be formed by methods other than or in addition to soldering, such as adhesion via an adhesive, heat staking the posts, or any other method of securing the overlapping joint. Alternatively, the edge portions of an FCB can be joined using both an overlapping joint (as described above) and an interlocking joint (see, e.g., Figure 38). For example, part of the edge portions can be joined by one or more overlapping joints and another part of the edge portions can be joined by one or more interlocking joints (e.g., the joint can alternate between overlapping joints and interlocking joints along a length of the joint).

As shown in Figure 42, the central engagement element 428 can include a keying feature 429 that is engageable with a keying feature of a receptacle to ensure rotational alignment with the receptacle. Although not shown, the central engagement element 428 can include a central receptacle interface, as described above, and one or more radio-frequency (RF) or magnetic field signal interference shields configured to block RF interference, magnetic field signals, and/or noise. Like the central engagement element 228, the central engagement element 428 includes an inner chamfer 472. Although not shown, the plug 402 can also include an outer chamfer, like the outer chamfer 270, formed in the housing of the plug 402. The inner chamfer 472 has an angled surface that faces toward an annular FCB 420 of a receptacle as the receptacle and the plug 402 are being mated (see, e.g., Figures 44 and 45). The inner chamfer 472 can be angled in the same manner as the inner chamfer 272.

Referring to Figures 44 and 45, with the central axis of the plug 402 aligned with a central axis of the receptacle, the plug 402 can be inserted into the receptacle. As the plug 402 is inserted into the receptacle, the flexible electrical contacts 442 engage corresponding ones of electrical contact pads 424 of the FCB 420 and establish an electrical connection with the electrical contact pads 424. Engagement includes radial flexing (i.e., flexing in a radial direction as shown via directional arrow in Figure 45) of the flexible electrical contacts 442 and sliding of the electrical contact points 487 along the flexible substrate 422 of the FCB 420 until the electrical contact points 487 come into contact with corresponding ones of the electrical contact pads 424.

To facilitate initial engagement with the flexible substrate 422 and initial radial flexing of the flexible electrical contacts 442, the movable portion 468 extends at a radially outward angle away from the elbow 469 toward the electrical contact point 487 in a receptacle-insertion direction 425. In other words, the movable portion 468 extends at a radially outward angle away from the leading edge of the plug 402 or leading edge of the central engagement element 428. For example, the fixed portion 486 extends away from the jog 484 towards the leading edge of the plug 402 and towards the elbow 469. From the elbow 469, the movable portion 468 extends away from the elbow and back towards the jog 484 such that the flexible electrical contact 442 reversed back upon itself. This is different than the flexible electrical contacts 142 or the flexible electrical contacts 242, where all portions of the flexible electrical contacts extend toward the leading edge of the plug in a direction from the fixed portion to the cantilevered end of the flexible electrical contacts. In other words, no portion of the flexible electrical contacts 142 or the flexible electrical contacts 242 extend toward the cantilevered end in a direction away from the leading edge of the plug.

The movable portion 468, extending in a direction away from the leading edge of the plug 402 provides a broad gradual angled surface that receives a leading edge of the annular FCB 420 and enables the leading edge to slide along the angled surface. As shown in Figure 45, as the leading edge of the annular FCB 420 contacts and slides along the movable portion 468 in the receptacle-insertion direction 425, the annular FCB 420 urges the movable portion 468 to flex radially inwardly toward the FCB 446 (as shown by a directional arrow 431). This contrasts with the flexible electrical contacts 142 and the flexible electrical contacts 242, which are urged to flex radially away from the FCB. After the annular FCB 420 is fully inserted, the electrical contact point 487 is in contact with a corresponding one of the electrical contact pads 424. The radially outwardly directed bias of the movable portion 468 applies a radially outwardly directed force to the electrical contact pad 424, which helps ensure the electrical contact point 487 establishes and maintains electrical contact with the electrical contact pad 424.

The electrical contact pads 424 and the flexible electrical contacts 442 are made of an electrically conductive material, such as metal (e.g., copper, phosphorus-bronze, beryllium-copper, or other electrically conductive spring alloys). In some examples, as mentioned above, the flexible electrical contacts 442 are made using a metal stamping process.

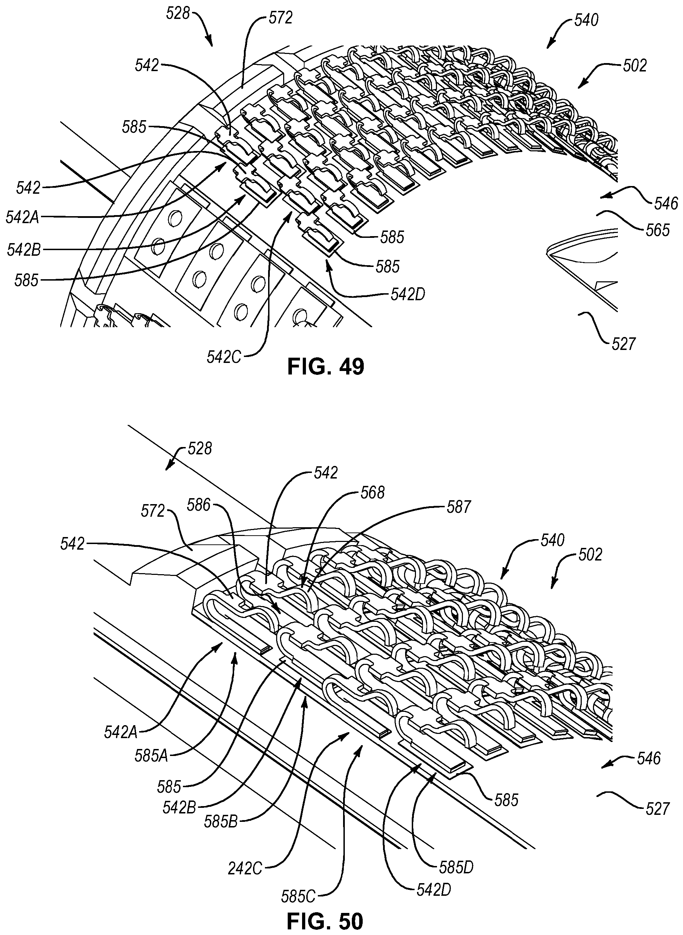

Referring Figures 49-53, another example of a plug 502 is shown. The plug 502 includes some features analogous to features of the plug 402. In fact, unless otherwise noted, like numbers (500-series for the plug 502 and 400-series for the plug 402) refer to analogous features. The plug 502 includes an electrical contact interface 540 that includes flexible electrical contacts 542 arranged in a set of annular patterns corresponding with a set of annular patterns of the electrical contact pads 124 forming the electrical contact-pad interface 123 of the annular FCB 120. Like the plug 402, the annular patterns of the flexible electrical contacts 542 and the mounting pads 585 are staggered relative to adjacent ones of the annular patterns. For example, the mounting pads 585 are grouped into a first mounting-pad pattern 585A, a second mounting-pad pattern 585B, a third mounting-pad pattern 585C, and a fourth mounting-pad pattern 585D, and the flexible electrical contacts 542 are grouped into a first contact pattern 542A, a second contact pattern 542B, a third contact pattern 542C, and a fourth contact pattern 542D, which correspond with the location and position of the first mounting-pad pattern 585A, the second mounting-pad pattern 585B, the third mounting-pad pattern 585C, and the fourth mounting-pad pattern 585D, respectively.

The flexible electrical contacts 542 are fixed to and extend from an outer surface 527 of a flexible substrate 565 of the annular FCB 546 of the plug 502. However, the size and shape of the flexible electrical contacts 542 and the way the flexible electrical contacts 542 are attached to the annular FCB 546 are different than that associated with the flexible electrical contacts 442 of the plug 402. For example, the mounting pads 585 of the FCB 546 do not have contact apertures 448 and no portion of the flexible electrical contacts 542 extends into or through the flexible substrate 565 of the FCB 546. Instead, the flexible electrical contacts 542 are soldered to a corresponding one of the mounting pads 585 using surface mount technology (SMT) techniques. Each one of the flexible electrical contacts 542 includes an electrical contact point 587 proximate a cantilevered end of a movable portion 568 of the flexible electrical contact 542. The movable portion 568 is connected to a fixed portion 586 via an elbow 569, which is resiliently deformable to enable the movable portion 568 to move relative to the fixed portion 586. The flexible electrical contacts 542 are attached to the FCB 546 so that the elbow 569 and the movable portion 568 of the flexible electrical contacts 542 of all the contact patterns are on the outer surface 527 of the flexible substrate 565 of the FCB 546. The fixed portion 586 is soldered directly to the mounting pad 585.

Referring to Figure 53, in some examples, the flexible electrical contacts 542 are soldered to the mounting pads 585 before the FCB 546 is shaped into a cylinder and attached to the central engagement element 528. According to certain examples, a contact assembly 511, similar to the contact assembly 411, can be used to enable efficient automatic or manual soldering of multiple flexible electrical contacts 542. The contact assembly 511 includes a spine 543 or fixture to which multiple flexible electrical contacts 542 are attached. The spine 543 can have fixture apertures 513 that help facilitate handling of the contact assembly 511 during shaping of the flexible electrical contacts 542 and placement of the contact assembly 511 relative to the FCB 546.

As shown in Figures 50-52, the FCB 546 is attached to the central engagement element 528 so that the inner surface 509 of the flexible substrate 565 is substantially flush with the outer surface of the central engagement element 528. Like the central engagement element 428, the central engagement element 528 includes an inner chamfer 572.

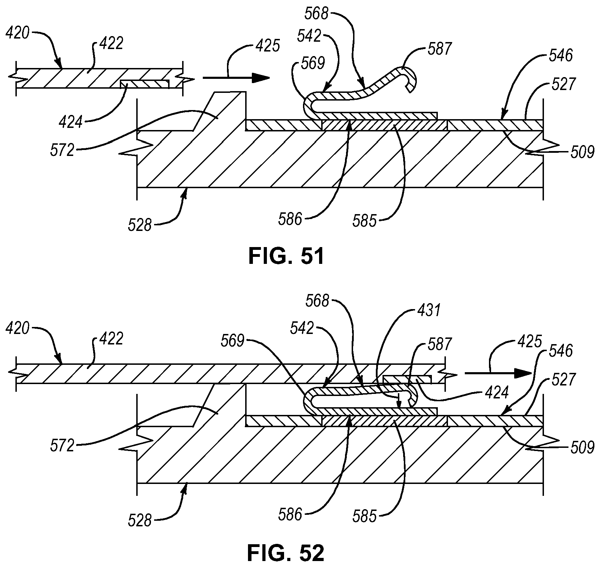

Referring to Figures 51 and 52, with the central axis of the plug 502 aligned with a central axis of the receptacle, the plug 502 can be inserted into the receptacle. As the plug 502 is inserted into the receptacle, the flexible electrical contacts 542 engage corresponding ones of electrical contact pads 424 of the FCB 420 and establish an electrical connection with the electrical contact pads 424. Engagement includes radial flexing of the flexible electrical contacts 542 and sliding of the electrical contact points 587 along the flexible substrate 422 of the FCB 420 until the electrical contact points 587 come into contact with corresponding ones of the electrical contact pads 424. Like the flexible electrical contacts 442 of the plug 402, to facilitate initial engagement with the flexible substrate 422 and initial radial flexing of the flexible electrical contacts 542, the movable portion 568 extends at a radially outward angle away from the elbow 569 toward the electrical contact point 587 in the receptacle-insertion direction 425. For example, from the elbow 569, the movable portion 568 extends away from the elbow 569 and back over the fixed portion 586 and thus back upon itself. As shown in Figure 52, as the leading edge of the annular FCB 420 contacts and slides along the movable portion 568, the annular FCB 420 urges the movable portion 568 to flex radially inwardly toward the FCB 546 (as shown by a directional arrow 431).

The electrical contact pads 524 and the flexible electrical contacts 542 are made of an electrically conductive material, such as metal (e.g., copper, phosphorus-bronze, beryllium-copper, or other electrically conductive spring alloys). In some examples, as mentioned above, the flexible electrical contacts 542 are made using a metal stamping process.

In the illustrated examples, the electrical contact pads 424 of the FCB 420 of the receptacle are located on the inner surface (e.g., inner diameter (ID)) of the FCB 420, and the flexible electrical contacts 442, 542 of the plug 402, 502, respectively, are mounted to the outer surface 427, 527 (e.g., outer diameter (OD)) of the FCB 446, 546, respectively. Because the FCB 420 and the FCB 446, 546 are cylindrically shaped, the electrical contact pads 424 of the FCB 420 are located on a concave surface the FCB 420, and the flexible electrical contacts 442, 542 are mounted to a convex surface of the FCB 446, 546, respectively.

However, in some examples, the above configuration can be reversed. In other words, in some examples, the electrical contact pads 424 of the FCB 420 of the receptacle can be located on the outer surface (e.g., OD) of the FCB 420, and the flexible electrical contacts 442, 542 of the plug 402, 502, respectively, can be mounted to the inner surface 409, 509 (e.g., ID) of the FCB 446, 546, respectively. This configuration can be visualized by considering the top of Figure 44 as being internal to (e.g., the internal cavity defined by) the FCB 446 and the bottom of Figure 44 as being external the FCB 446. Because the FCB 420 and the FCB 446, 546 are cylindrically shaped, in these alternative examples, the electrical contact pads 424 of the FCB 420 are located on a convex surface the FCB 420, and the flexible electrical contacts 442, 542 are mounted to a concave surface of the FCB 446, 546, respectively. When the plug is inserted into the receptacle in these alternative examples, the FCB 420 is inserted within the FCB 446, 546, respectively.

Additionally, it is recognized that in some embodiments the electrical connection features of the electrical connector having the plug 402 can be reversed without departing from the essence of the present disclosure. For example, the receptacle can include the flexible electrical contacts 442 and the plug can include electrical contact pads. In other words, labels and need not connote certain functionality or features associated with conventional plugs and receptacles. Accordingly, in some examples and according to a broad interpretation, the plug of the electrical connectors disclosed herein can be considered a receptacle, and the receptacles of the electrical connectors disclosed herein can be considered a plug. Accordingly, as used herein, a plug of an electrical connector is merely a first portion (or first connector element) of the electrical connector and a receptacle of the electrical connector is merely a second portion (or second connector element) of the electrical connector, or vice versa.

Reference throughout this specification to features, advantages, or similar language does not imply that all of the features and advantages that may be realized with the subject matter of the present disclosure should be or are in any single embodiment. Rather, language referring to the features and advantages is understood to mean that a specific feature, advantage, or characteristic described in connection with an embodiment is included in at least one embodiment of the present disclosure. Thus, discussion of the features and advantages, and similar language, throughout this specification may, but do not necessarily, refer to the same embodiment.

In the above description, certain terms may be used such as "up," "down," "upper," "lower," "horizontal," "vertical," "left," "right," "over," "under" and the like. These terms are used, where applicable, to provide some clarity of description when dealing with relative relationships. But these terms are not intended to imply absolute relationships, positions, and/or orientations. For example, with respect to an object, an "upper" surface can become a "lower" surface simply by turning the object over. Nevertheless, it is still the same object. Further, the terms "including," "comprising," "having," and variations thereof mean "including but not limited to" unless expressly specified otherwise. An enumerated listing of items does not imply that any or all of the items are mutually exclusive and/or mutually inclusive, unless expressly specified otherwise. The terms "a," "an," and "the" also refer to "one or more" unless expressly specified otherwise. Further, the term "plurality" can be defined as "at least two." Moreover, unless otherwise noted, as defined herein a plurality of particular features does not necessarily mean every particular feature of an entire set or class of the particular features.

Additionally, instances in this specification where one element is "coupled" to another element can include direct and indirect coupling. Direct coupling can be defined as one element coupled to and in some contact with another element. Indirect coupling can be defined as coupling between two elements not in direct contact with each other, but having one or more additional elements between the coupled elements. Further, as used herein, securing one element to another element can include direct securing and indirect securing. Additionally, as used herein, "adjacent" does not necessarily denote contact. For example, one element can be adjacent to another element without being in contact with that element.

As used herein, the phrase "at least one of", when used with a list of items, means different combinations of one or more of the listed items may be used and only one of the items in the list may be needed. The item may be a particular object, thing, or category. In other words, "at least one of" means any combination of items or number of items may be used from the list, but not all of the items in the list may be required. For example, "at least one of item A, item B, and item C" may mean item A; item A and item B; item B; item A, item B, and item C; or item B and item C. In some cases, "at least one of item A, item B, and item C" may mean, for example, without limitation, two of item A, one of item B, and ten of item C; four of item B and seven of item C; or some other suitable combination.

Unless otherwise indicated, the terms "first," "second," etc. are used herein merely as labels, and are not intended to impose ordinal, positional, or hierarchical requirements on the items to which these terms refer. Moreover, reference to, e.g., a "second" item does not require or preclude the existence of, e.g., a "first" or lower-numbered item, and/or, e.g., a "third" or higher-numbered item.

As used herein, a system, apparatus, structure, article, element, component, or hardware "configured to" perform a specified function is indeed capable of performing the specified function without any alteration, rather than merely having potential to perform the specified function after further modification. In other words, the system, apparatus, structure, article, element, component, or hardware "configured to" perform a specified function is specifically selected, created, implemented, utilized, programmed, and/or designed for the purpose of performing the specified function. As used herein, "configured to" denotes existing characteristics of a system, apparatus, structure, article, element, component, or hardware which enable the system, apparatus, structure, article, element, component, or hardware to perform the specified function without further modification. For purposes of this disclosure, a system, apparatus, structure, article, element, component, or hardware described as being "configured to" perform a particular function may additionally or alternatively be described as being "adapted to" and/or as being "operative to" perform that function.

The present subject matter may be embodied in other specific forms without departing from its spirit or essential characteristics. The described embodiments are to be considered in all respects only as illustrative and not restrictive. All changes which come within the meaning and range of equivalency of the claims are to be embraced within their scope.

When used in this specification and claims, the terms "comprises" and "comprising" and variations thereof mean that the specified features, steps or integers are included. The terms are not to be interpreted to exclude the presence of other features, steps or components.

The invention may also broadly consist in the parts, elements, steps, examples and/or features referred to or indicated in the specification individually or collectively in any and all combinations of two or more said parts, elements, steps, examples and/or features. In particular, one or more features in any of the embodiments described herein may be combined with one or more features from any other embodiment(s) described herein.

Protection may be sought for any features disclosed in any one or more published documents referenced herein in combination with the present disclosure.

Although certain example embodiments of the invention have been described, the scope of the appended claims is not intended to be limited solely to these embodiments. The claims are to be construed literally, purposively, and/or to encompass equivalents.

## Claims

1. An electrical connector, comprising:
a first connector element comprising:
a first annular flexible circuit board; and
first electrical contacts coupled to the first annular flexible circuit board, electrically isolated from each other, and arranged in at least one first annular pattern; and
a second connector element comprising:
a leading end;
a second annular flexible circuit board; and
second electrical contacts coupled to the second annular flexible circuit board, electrically isolated from each other, and arranged in at least one second annular pattern, wherein each one of the second electrical contacts is a flexible electrical contact that comprises a fixed portion directly attached to the second annular flexible circuit board and a movable portion that is movable relative to the fixed portion, and wherein the movable portion is radially outwardly angled away from the leading end of the second connector element;
wherein:
the leading end of the second connector element is selectively connectable with the first connector element; and
when the second connector element is selectively connected with the first connector element, each one of the first electrical contacts of the first connector element is in physical contact with a corresponding one of the second electrical contacts of the second connector element.

2. The electrical connector according to claim 1, wherein the first electrical contacts of the first connector element are electrical contact pads.

3. The electrical connector according to claim 1 or 2, wherein:
the first annular flexible circuit board of the first connector element comprises a first outer surface and a first inner surface separated from the first outer surface by a thickness of the first annular flexible circuit board;
the at least one first annular pattern is attached to the first inner surface of the first annular flexible circuit board;
the second annular flexible circuit board of the second connector element comprises a second outer surface and a second inner surface separated from the first outer surface by a thickness of the second annular flexible circuit board; and
the at least one second annular pattern is attached to the second outer surface of the second annular flexible circuit board.

4. The electrical connector according to claim 3, wherein:
the first connector element comprises a plurality of first annular patterns attached to the first inner surface of the first annular flexible circuit board and spaced apart from each other; and
the second connector element comprises a plurality of second annular patterns attached to the second outer surface of the second annular flexible circuit board and spaced apart from each other.

5. The electrical connector according to any of claims 1 to 4, wherein the movable portion of each one of the flexible electrical contacts comprises an elongated arm that extends, in a direction away from the leading end of the second connector element, from a fixed end, fixed to the fixed portion, to a cantilevered end.

6. The electrical connector according to any preceding claim, wherein:
the second annular flexible circuit board comprises mounting pads electrically isolated from each other and arranged in at least one mounting-pad annular pattern; and
the fixed portion of each one of the flexible electrical contacts is electrically and mechanically coupled directly with a corresponding one of the mounting pads.

7. The electrical connector according to claim 6, wherein:
the fixed portion of each one of the flexible electrical contacts comprises a jog;
each one of the mounting pads comprises a contact aperture; and
the jog of the fixed portion of each one of the flexible electrical contacts extends through the contact aperture of the corresponding one of the mounting pads.

8. The electrical connector according to claim 7, wherein the jog of the fixed portion of each one of the flexible electrical contacts is soldered to the corresponding one of the mounting pads.

9. The electrical connector according to claim 7 or 8, wherein:
the second connector element further comprises a central engagement element;
the second annular flexible circuit board is attached to the central engagement element;
the central engagement element comprises at least one annular channel; and
the jog of the fixed portion of each one of the flexible electrical contacts arranged in the at least one second annular pattern extends into the at least one annular channel.

10. The electrical connector according to any one of claims 6 to 9, wherein the fixed portion of each one of the flexible electrical contacts is electrically and mechanically coupled directly with the corresponding one of the mounting pads via surface mount technology.

11. The electrical connector according to any preceding claim, wherein at least one of:
the first connector element comprises a first housing that comprises a plurality of posts, the first annular flexible circuit board comprises opposing first side portions overlapping each other and each comprising a plurality of openings, each one of the openings of a first one of the opposing first side portions is aligned with a corresponding one of the openings of a second one of the opposing first side portions, and each one of the plurality of posts passes through a corresponding one of multiple pairs of aligned openings of the opposing first side portions; or
the second connector element comprises a second housing that comprises a plurality of posts, the second annular flexible circuit board comprises opposing second side portions overlapping each other and each comprising a plurality of openings, each one of the openings of a first one of the opposing second side portions is aligned with a corresponding one of the openings of a second one of the opposing second side portions, and each one of the plurality of posts passes through a corresponding one of multiple pairs of aligned openings of the opposing second side portions.

12. The electrical connector according to claim 11, wherein:
when the first connector element comprises a first housing that comprises a plurality of posts, each one of the plurality of posts has a retention portion larger than the aligned openings of the corresponding one of the multiple pairs of aligned openings of the opposing first side portions so that each one of the multiple pairs of aligned openings of the opposing first side portions is retained on a corresponding one of the plurality of posts; and
when the second connector element comprises a second housing that comprises a plurality of posts, each one of the plurality of posts has a retention portion larger than the aligned openings of the corresponding one of the multiple pairs of aligned openings of the opposing second side portions so that each one of the multiple pairs of aligned openings of the opposing second side portions is retained on a corresponding one of the plurality of posts; and/or
wherein:
when the first connector element comprises a first housing that comprises a plurality of posts, the plurality of posts of the first housing are retained within the multiple pairs of aligned openings via an adhesive; and
when the second connector element comprises a second housing that comprises a plurality of posts, the plurality of posts of the second housing are retained within the multiple pairs of aligned openings via an adhesive.

13. The electrical connector according to any preceding claim, wherein at least one of:
the first annular flexible circuit board comprises opposing first side portions joined together by a plurality of first solder bridges; and/or
the second annular flexible circuit board comprises opposing second side portions joined together by a plurality of second solder bridges; and/or
wherein at least one of:
the first annular flexible circuit board comprises opposing first side portions overlapping each other and joined together by solder; and/or
the second annular flexible circuit board comprises opposing second side portions overlapping each other and joined together by solder.

14. The electrical connector according to any preceding claim, wherein the second connector element comprises an inner annular chamfer configured to slidably engage the first annular flexible circuit board as the second connector element is selectively connected with the first connector element and when the first annular flexible circuit is radially inwardly lopsided; and/or
wherein the second connector element comprises an outer annular chamfer configured to slidably engage the first annular flexible circuit board as the second connector element is selectively connected with the first connector element and when the first annular flexible circuit is radially outwardly lopsided; or
wherein the second connector element comprises an outer annular chamfer configured to slidably engage the first annular flexible circuit board as the second connector element is selectively connected with the first connector element and when the first annular flexible circuit is radially outwardly lopsided and wherein:
the second connector element comprises an inner annular chamfer configured to slidably engage the first annular flexible circuit board as the second connector element is selectively connected with the first connector element and when the first annular flexible circuit is radially inwardly lopsided; and
the inner annular chamfer is axially offset, along a central axis of the electrical connector, relative to the outer annular chamfer.

15. The electrical connector according to any preceding claim, wherein:
the first electrical contacts are arranged in at least two first annular patterns;
the first electrical contacts of a first one of the at least two first annular patterns are staggered relative to the first electrical contacts of a second one of the at least two first annular patterns;
the second electrical contacts are arranged in at least two second annular patterns; and
the second electrical contacts of a first one of the at least two second annular patterns are staggered relative to the second electrical contacts of a second one of the at least two second annular patterns; and/or
wherein:
the first connector element further comprises a first central interface concentric with the first annular flexible circuit board, located radially inwardly relative to the first annular flexible circuit board, and comprising at least one of a first electrical connector, a first fluidic connector, a first fiberoptic connector, or a first pneumatic connector;
the second connector element further comprises a second central interface concentric with the second annular flexible circuit board, located radially inwardly relative to the second annular flexible circuit board, and comprising at least one of a second electrical connector, a second fluidic connector, a second fiberoptic connector, or as second pneumatic connector; and
when the second connector element is selectively connected with the first connector element the at least one of the first electrical connector, the first fluidic connector, the first fiberoptic connector, or the first pneumatic connector is electrically, fluidically, fiberoptically, or pneumatically connected with a corresponding one of the at least one of the second electrical connector, the second fluidic connector, the second fiberoptic connector, or the second pneumatic connector.
